(19) Europäisches Patentamt
European Patent Office
Office européen des brevets

(11)  **EP 1 626 285 B1**

(12)  **EUROPÄISCHE PATENTSCHRIFT**

(45) Veröffentlichungstag und Bekanntmachung des Hinweises auf die Patenterteilung:
**23.05.2018  Patentblatt 2018/21**

(51) Int Cl.:
***G01R 23/16*** *(2006.01)*

(21) Anmeldenummer: **05015163.8**

(22) Anmeldetag: **12.07.2005**

(54) **Verfahren zur Ermittlung der komplexen Spektrallinien eines Signals**

Method for Determining the Complex Spectral Lines of a Signal

Procédé pour déterminer les lignes spectrales complexes d'un signal

(84) Benannte Vertragsstaaten:
**DE FR GB**

(30) Priorität: **13.08.2004  DE 102004039441**

(43) Veröffentlichungstag der Anmeldung:
**15.02.2006  Patentblatt 2006/07**

(73) Patentinhaber: **Rohde & Schwarz GmbH & Co. KG**
**81671 München (DE)**

(72) Erfinder:
• **Eckert, Hagen**
**86415 Mering (DE)**
• **Pliquett, Jochen**
**76571 Gaggenau (DE)**

(74) Vertreter: **Körfer, Thomas et al**
**Mitscherlich PartmbB**
**Patent- und Rechtsanwälte**
**Postfach 33 06 09**
**80066 München (DE)**

(56) Entgegenhaltungen:
**US-A- 5 165 051          US-A- 5 420 501**
**US-A1- 2003 014 203**

• LORENZ R D ET AL: "Exact inverter waveform analysis using Z-transform estimation techniques" IEEE, 11. April 1988 (1988-04-11), Seiten 525-532, XP010070202
• ROLAIN Y ET AL: "Design and implementation of a fast logarithmic stepped sine for a fixed sample rate digital network analyser" IEEE, 25. April 1989 (1989-04-25), Seiten 457-461, XP010085150
• SCHOUKENS J ET AL: "The interpolated fast Fourier transform: a comparative study" INSTRUMENTATION AND MEASUREMENT TECHNOLOGY CONFERENCE. ATLANTA, MAY 14, Bd. CONF. 8, 14. Mai 1991 (1991-05-14), Seiten 358-364, XP010036976 ISBN: 0-87942-579-2

**Beschreibung**

Die Erfindung betrifft ein Verfahren zur Ermittlung der komplexen Spektrallinien eines Signals.

Diskrete Spektrallinien innerhalb des Frequenzspektrums eines Signals resultieren aus harmonischen Signalanteilen dieses Signals. Die meßtechnische Erfassung von Spektrallinien hinsichtlich Amplitude, Phase und Spektralfrequenz erfolgt üblicherweise mit Spektrumanalysatoren. Hierzu sei beispielsweise auf die DE 101 05 258 A1 verwiesen.

Die US 2003/014203 A1 offenbart eine Methode und eine Vorrichtung zur Ermittlung der Amplituden von Spektrallinien in einem Leistungsspektrum eines abgetasteten nichtkohärenten Signals. Hierbei findet ein Maximum-Likelihood-Ansatz Anwendung, bei dem über einen bestimmten Beobachtungszeitraum ein rauschbehaftetes Signal gemessen wird und die Fehlerquadrate zwischen dem rauschbehafteten Meßsignal und einem ideal rauschfreien, die gesuchten Parameter enthaltenden Signal über einen bestimmten Beobachtungszeitraum minimiert werden. Die Minimierung der Fehlerquadrate führt auf ein lineares Gleichungssystem, dessen Lösung unter Anwendung eines numerischen Verfahrens zu den einzelnen Parametern des idealen rauschfreien Signals führt. Somit ermittelt das in diesem Dokument offenbarte Verfahren nur reelle Amplituden von Spektrallinien im Leistungsspektrum eines rauschbehafteten Messignals. Dieses Dokument ist der nächstkommende Stand der Technik, da es ein Maximum-Likelihood-Verfahren zur Bestimmung der Amplitude eines rauschbehafteten Empfangssignals ohne Zwischenschaltung einer Demodulation anwendet.

Die im Frequenzbereich operierenden Analyseverfahren der Spektrumanalysatoren weisen eine Reihe von Nachteilen auf. Fourier-Analysatoren erfassen aufgrund der Bandbegrenzung durch die eingesetzten Analog-Digital-Wandler keine höheren Spektralfrequenzen und sind von Leck-Effekten betroffen. Spektrumanalysatoren mit abstimmbaren Bandpaßfiltern weisen nur eine begrenzte Auflösung auf. Spektrumanalysatoren nach den Überlagerungsprinzip führen aufgrund der eingesetzten Mischer- und Verstärkereinheiten schließlich zu linearen und nicht-linearen Verzerrungen des zu analysierenden Signals und weisen bei überlagertem Rauschen einen reduzierten Dynamikbereich auf. Schließlich geht bei allen im Frequenzbereich operierenden Analyseverfahren die Information bezüglich der Phase der Spektrallinien meist verloren.

Der Erfindung liegt deshalb die Aufgabe zugrunde, ein Analyseverfahren zur Erfassung von Spektrallinien innerhalb des Frequenzspektrums eines Signals zu schaffen, mit dem die obengenannten Nachteile der frequenzbereichsorientierten Analyseverfahren beseitigt sind.

Die Aufgabe der Erfindung wird durch ein Verfahren zur Ermittlung von komplexen Spektrallinien eines Signals mit den Merkmalen des Anspruchs 1 gelöst.

Zur Vermeidung oben genannter Nachteile, die für frequenzbereichsorientierte Analyseverfahren typisch sind, ist das erfindungsgemäße Verfahren auf den Zeitbereich konzentriert. Da die Überlagerung mehrfrequenter Signalanteile in einem Signal im Zeitbereich eine eindeutige Unterscheidung der drei Signalkenngrößen Amplitude, Phase und Frequenz der einzelnen harmonischen Signalanteilen unmöglich macht, wird im erfindungsgemäßen Verfahren die Frequenz der einzelnen harmonischen Signalanteile als bekannt vorausgesetzt und darauf aufbauend die beiden Signalkenngrößen Amplitude und Phase der einzelnen Signalanteile des Signals bestimmt.

Die Voraussetzung der Kenntnis der Frequenzen der einzelnen harmonischen Spektralanteile des Signals muß nicht als Einschränkung gewertet werden, da die Spektralfrequenzen eines Nutzsignals, beispielsweise eines amplitudenmodulierten Zwischen- oder Hochfrequenzsignals, auf Grund der Kenntnis der Trägerfrequenz und der Frequenz des Basisbandsignals auch unter Berücksichtigung von möglicherweise vorliegenden nicht-linearen Verzerrungen im allgemeinen feststehen. Auch die Spektralfrequenzen der Spektralanteile in einem Störsignal - beispielsweise Nebenlinien eines digitalen Frequenzsynthesizers oder Spektralanteile im Netzbrummen - sind im allgemeinen bestimmbar.

Unter Anwendung des Maximum-Likelihood-Verfahrens, bei dem das Fehlerbetragsquadrat zwischen einem rauschbehafteten und einem dazu korrespondierenden ideal rauschfreien Signal über einen Beobachtungszeitraum minimiert wird, entsteht ein lineares Gleichungssystem, dessen Lösung die komplexen Spektrallinien - Amplitude und Phase der Spektrallinien - der einzelnen Signalanteile des ideal rauschfreien Signals darstellen. Beim erfindungsgemäßen Verfahren wird hierzu das rauschbehaftete Signal über den Beobachtungszeitraum gemessen und damit unter Berücksichtigung aller bekannten Spektralfrequenzen die Koeffizienten der "System"-Matrix und des Vektors der "rechten Gleichungsseite" des linearen Gleichungssystems ermittelt. Unter Zuhilfenahme eines numerischen Verfahrens - beispielsweise Cholesky-Verfahren - wird das somit ermittelte lineare Gleichungssystem zur Bestimmung der einzelnen komplexen Spektrallinien gelöst.

Eine Einschränkung des zu betrachtenden Frequenzbereiches liegt beim erfindungsgemäßen Verfahren nicht vor, da alle Spektralfrequenzen berücksichtigt werden. Auch Leck-Effekte und zu geringe Frequenzauflösung sind aufgrund fehlender Frequenzrasterung und genauer Kenntnis der zu betrachtenden Spektralfrequenzen beim erfindungsgemäßen Verfahren nicht anzutreffen. Falls das Meßgerät näherungsweise verzerrungsfrei arbeitet, ist das Meßsignal beim erfindungsgemäßen Verfahren weitestgehend von linearen und/oder nicht-linearen Verzerrungen befreit, da das erfindungsgemäße Verfahren keine zusätzlichen verzerrenden Übertragungsglieder benötigt.

Vorteilhafte Ausgestaltungen der Erfindung, insbesondere Anwendungsformen des erfindungsgemäßen Verfahrens, sind in den abhängigen Ansprüchen angegeben.

Durch Schätzung der komplexen Spektrallinien bei der Trägerfrequenz und bei der Frequenz des oberen oder unteren Seitenbandes kann für ein amplitudenmoduliertes Signal mit Hilfe des erfindungsgemäßen Verfahrens der Modulationsgrad des amplitudenmodulierten Signals ermittelt werden.

Durch Variation der Frequenz des unmodulierten Signals einer Amplitudenmodulation und Bestimmung der Amplitude bzw. der Phase der komplexen Spektrallinie am jeweiligen oberen oder unteren Seitenband kann mit Hilfe des erfindungsgemäßen Verfahrens die relative Amplituden- und Phasenverzerrung des amplitudenmodulierten Signals relativ zur Trägerfrequenz gewonnen werden.

Das erfindungsgemäße Verfahren ermöglicht auch die Bestimmung der komplexen Spektrallinien von Höherharmonischen oder Intermodulationsprodukten eines in einem nicht-linearen Übertragungsglied nicht-linear verzerrten Signals und eine darauf aufbauende Kompensation dieser komplexen Spektrallinien.

Insbesondere bei N-Ton-Signalen mit insgesamt N verschiedenen Grundschwingungen entstehen eine Vielzahl an Intermodulationsprodukten. Das erfindungsgemäße Verfahren ermöglicht das Übertragungsverhalten für Spektrallinien von Intermodulationsprodukten gleicher Ordnung für verschiedene Leistungspegel zu ermitteln und damit die Leistungsverteilung zwischen den Spektralanteilen gleicher Ordnung für unterschiedliche Leistungspegel zu gewinnen.

Ist die Spektralfrequenz eines harmonischen Störsignals - beispielsweise ein Netzbrummen oder eine in Frequenzsynthesizern erzeugte Nebenlinien -, das einem Nutzsignal überlagert ist, bekannt, so ermöglicht das erfindungsgemäße Verfahren die Bestimmung der Amplitude und Phase der jeweiligen Spektrallinie, womit ein Kompensationssignal generiert werden kann, das dem gestörten Nutzsignal zur Kompensation des harmonischen Störsignals überlagert wird.

Bei Mehrträgerverfahren - beispielsweise beim OFDM-(Orthogonal Frequency Division Multiplexing) Verfahren - werden oftmals wahlweise mehrere unterschiedliche OFDM-Signale übertragen. Diese OFDM-Signale unterscheiden sich jeweils in der Trägerkonfiguration, d.h. im Frequenzabstand der einzelnen Träger und in der Belegung des Trägerfrequenzrasters mit Trägern. Das erfindungsgemäße Verfahren bietet die Möglichkeit, aus dem empfangenen OFDM-Signal die jeweils vorliegende Trägerkonfiguration zu bestimmen, falls sich die Trägerkonfigurationen der einzelnen OFDM-Signale jeweils mindestens an einer Trägerfrequenz unterscheiden. Für jede Trägerkonfiguration werden mit dem erfindungsgemäßen Verfahren die komplexen Spektrallinien des empfangenen OFDM-Signals bei den einzelnen Trägerfrequenzen der jeweiligen Trägerkonfiguration erfaßt und einer Bewertung zugeführt. Bei dem zum Beobachtungszeitraum übertragenen OFDM-Signal werden vom erfindungsgemäßen Verfahren die komplexen Spektrallinien bei den zur jeweiligen Trägerkonfiguration gehörigen Trägerfrequenzen erfaßt. Diese führen zu einer im Vergleich mit anderen OFDM-Signalen, welche zum Beobachtungszeitraum nicht übertragen werden, maximalen Bewertung.

Schließlich bietet das erfindungsgemäße Verfahren die Möglichkeit, die komplexe Amplitude eines harmonischen Zeitsignals zu bestimmen, das nur über einen Zeitraum gemessen wurde, der kleiner als die Periodendauer des harmonischen Zeitsignals ist.

Eine Ausführungsform des Verfahrens zur Bestimmung der komplexen Spektrallinien eines Signals wird nachfolgend unter Bezugnahme auf die Zeichnung näher erläutert. In der Zeichnung zeigen:

Fig. 1        ein Flußdiagramm des erfindungsgemäßen Verfahrens zur Ermittlung der komplexen Spektrallinien eines Signals,

Fig. 2        ein Flußdiagramm eines ersten Anwendungsbeispiels des erfindungsgemäßen Verfahrens zur Ermittlung der komplexen Spektrallinien eines Signals,

Fig. 3        ein Linienspektrum zum ersten Anwendungsbeispiel des erfindungsgemäßen Verfahrens zur Ermittlung der konplexen Spektrallinien eines Signals,

Fig. 4        ein Flußdiagramm des zweiten Anwendungsbeispiels des erfindungsgemäßen Verfahrens zur Ermittlung der komplexen Spektrallinien eines Signals,

Fig. 5        ein Linienspektrum zum zweiten Anwendungsbeispiel des erfindungsgemäßen Verfahrens zur Ermittlung der komplexen Spektrallinien eines Signals,

Fig. 6        ein Flußdiagramm eines dritten Anwendungsbeispiels des erfindungsgemäßen Verfahrens zur Ermittlung der komplexen Spektrallinien eines Signals,

Fig. 7        ein Linienspektrum zum dritten Anwendungsbeispiel des erfindungsgemäßen Verfahrens zur Ermittlung der komplexen Spektrallinien eines Signals,

Fig. 8          ein Linienspektrum zum vierten Anwendungsbeispiel des erfindungsgemäßen Verfahrens zur Ermittlung der komplexen Spektrallinien eines Signals,

Fig. 9          eine grafische Darstellung der Übertra gungskennlinien von Spektrallinien gleicher Ordnung bei nichtlinearer Verzerrung,

Fig. 10         ein Flußdiagramm eines vierten Anwendungsbeispiels des erfindungsgemäßen Verfahrens zur Ermittlung der komplexen Spektrallinien eines Signals,

Fig. 11         ein Flußdiagramm eines fünften Anwendungsbeispiels des erfindungsgemäßen Verfahrens zur Ermittlung der komplexen Spektrallinien eines Signals,

Fig. 12A,12B    ein Amplituden- und Phasengang eines mit einem harmonischen Störsignal gestörten Nutzsignals,

Fig. 13         ein Flußdiagramm eines sechsten Anwendungsbeispiels des erfindungsgemäßen Verfahrens zur Ermittlung der komplexen Spektrallinien eines Signals,

Fig. 14A,14B    ein Linienspektrum vor und nach Ausführung des sechsten Anwendungsbeispiels des erfindungsgemäßen Verfahrens zur Ermittlung der komplexen Spektrallinien eines Signals und

Fig. 15         ein Gleichungssystem des erfindungsgemäßen Verfahrens.

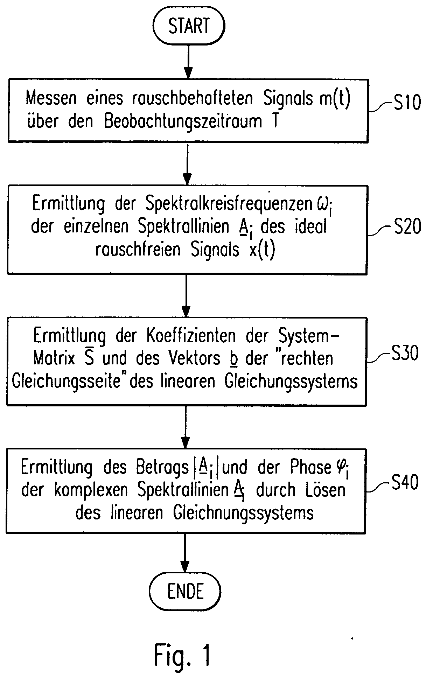

Bevor auf die detaillierte Beschreibung des erfindungsgemäßen Verfahrens zur Ermittlung der komplexen Spektrallinien eines Signals x(t) in Fig. 1 eingegangen wird, werden im Folgenden die mathematischen Grundlagen des erfindungsgemäßen Verfahrens hergeleitet.

Ausgangspunkt des erfindungsgemäßen Verfahrens ist ein ideal rauschfreies Signal x(t), das gemäß Gleichung (1) aus einer Summe komplexer harmonischer Signalanteile $\underline{A}_i \cdot e^{j\omega_i t}$ besteht. Diese komplexen harmonischen Signalanteile $\underline{A}_i \cdot e^{j\omega_i t}$ weisen komplexe Spektrallinien $\underline{A}_i$, bestehend aus einem Betrag $|\underline{A}_i|$ und einer Phase $\varphi_i$, auf, welche als komplexe Drehzeiger mit einer bestimmten Spektralkreisfrequenz $\omega_i$ rotieren.

$$x(t) = \sum_{i=1}^{N} \underline{A}_i * e^{j\omega_i t} = \sum_{i=1}^{N} |\underline{A}_i| * e^{j\varphi_i} * e^{j\omega_i t} \qquad (1)$$

Für den Fall reellwertiger Cosinus-Funktionen kann man gemäß Gleichung (2a) schreiben:

$$x(t) = \sum_{i=1}^{N/2} |\tilde{\underline{A}}_i| * \cos\left(\tilde{\omega}_i t + \tilde{\varphi}_i\right) \qquad (2a)$$

wobei $|\tilde{\underline{A}}_i|$ die Amplitude, $\tilde{\varphi}_i$ die Phasenverschiebung und $\tilde{\omega}_i$ die Kreisfrequenz der jeweiligen Cosinus-Funktion darstellt.

Mit $\cos(x) = \dfrac{1}{2}(e^{jx} + e^{-jx})$ ergibt sich Gleichung (2b)

$$x(t) = \sum_{i=1}^{N/2} \frac{|\tilde{\underline{A}}_i|}{2} * e^{j\varphi_i} * (e^{j(\tilde{\omega}_i t + \varphi_k)} + e^{-j(\omega_i t + \varphi_k)})$$

$$= \sum_{k=1}^{N/2} \left[ \frac{|\tilde{\underline{A}}_k|}{2} * e^{j\varphi_k} \right] * e^{j\tilde{\omega}_k t} + \sum_{k=1}^{N/2} \left[ \frac{|\tilde{\underline{A}}_k|}{2} * e^{-j\varphi_k} \right] * e^{-j\tilde{\omega}_k t} \qquad (2b)$$

Wir setzen nun

$$\underline{A}_i := \left[\frac{\left|\underline{\tilde{A}}_k\right|}{2} * e^{j\tilde{\varphi}_k}\right]; \quad \text{und} \quad \omega_i := \tilde{\omega}_k; \quad \forall i = k \Rightarrow i \in \left\{1, ..., \frac{N}{2}\right\}$$

$$\underline{A}_i := \left[\frac{\left|\underline{\tilde{A}}_k\right|}{2} * e^{-j\tilde{\varphi}_k}\right]; \quad \text{und} \quad \omega_i := -\tilde{\omega}_k; \quad \forall i = k + \frac{N}{2} \Rightarrow i \in \left\{\frac{N}{2}+1, ..., N\right\}$$

$$(2c)$$

und erhalten eine Gleichung (2d), die sich wie Gleichung (1) schreiben läßt.

$$x(t) = \sum_{k=1}^{N/2} \underline{A}_k * e^{j\omega_k t} + \sum_{k=N/2+1}^{N} \underline{A}_k * e^{j\omega_k t} = \sum_{k=1}^{N} \underline{A}_k * e^{j\omega_k t} \qquad (2d)$$

Für die Bestimmung der komplexen Spektrallinien $\underline{A}_i$ des ideal rauschfreien Signals x(t) wird das Maximum-Likelihood-Verfahren benutzt. Beim Maximum-Likelihood-Verfahren werden die Fehlerbetragsquadrate zwischen einem über einen Beobachtungszeitraum T gemessenen rauschbehafteten Signal m(t) und dem dazugehörigen ideal rauschfreien Signal x(t) minimiert. Das Minimierungskriterium ist Ausgangspunkt für die Bestimmung der komplexen Spektral-linien $\underline{A}_i$ des ideal rauschfreien Signals x(t). Als Minimierungskriterium des Maximum-Likelihood-Verfahrens dient gemäß Gleichung (3) die Metrik M.

$$M = \int_0^T \left|m(t) - x(t)\right|^2 dt = \int_0^T \left|m(t) - \sum_{i=1}^{N} \underline{A}_i e^{j\omega_i t}\right|^2 dt \qquad (3)$$

Zur Minimierung der Metrik M im Hinblick auf die Ermittlung der komplexen Spektrallinien $\underline{A}_i$ des ideal rausch-freien Signals x(t) wird gemäß Gleichung (4) die erste komplexe Ableitung der Metrik M nach der komplexen Spektrallinie $\underline{A}_i$ oder äquivalent nach der konjugiert komplexen Spektrallinie $\underline{A}_i^*$ gebildet und zu Null gesetzt.

$$\frac{\partial M}{\partial \underline{A}_i} = \int_0^T \frac{\partial \left|m(t) - x(t)\right|^2}{\partial \underline{A}_i} dt = \frac{\partial M}{\partial \underline{A}_i^*} = \int_0^T \frac{\partial \left|m(t) - x(t)\right|^2}{\partial \underline{A}_i^*} dt = 0 \qquad (4)$$

Das Fehlerbetragsquadrat |m(t)-x(t)|² in Gleichung (4) wird durch das Produkt der komplexen Signaldifferenz mit der dazu konjugiert komplexen Signaldifferenz ersetzt und führt nach mathematischer Umformung zu der in Gleichung (5) dargestellten äquivalenten Beziehung des Fehlerbetragsquadrats |m(t)-x(t)|².

$$|m(t) - x(t)|^2 = \left(m(t) - \sum_{i=1}^{N} \underline{A}_i * e^{j\omega_i t}\right) * \left(m(t) - \sum_{i=1}^{N} \underline{A}_i * e^{j\omega_i t}\right)^* =$$

$$= |m(t)|^2 - m(t) \cdot \sum_{i=1}^{N} \underline{A}_i^* * e^{-j\omega_i t} - m(t)^* \cdot \sum_{i=1}^{N} \underline{A}_i * e^{j\omega_i t} +$$

$$\sum_{i=1}^{N} \underline{A}_i * e^{j\omega_i t} \cdot \sum_{i=1}^{N} \underline{A}_i^* * e^{-j\omega_i t} \qquad (5)$$

Zur Minimierung der Metrik M wird die mathematische Beziehung für das Fehlerbetragsquadrats |m(t)-x(t)|² gemäß Gleichung (5) in Gleichung (4) eingesetzt, woraus die mathematische Beziehung in Gleichung (6) hervorgeht.

$$\int_0^T \frac{\partial \left|m(t) - x(t)\right|^2}{\partial \underline{A}_i^*} \, dt \;=\; -\int_0^T m(t) * e^{-j\omega_i t} dt \;+\; \int_0^T \sum_{k=1}^N \underline{A}_k e^{j(\omega_k - \omega_i)t} dt = 0* \qquad (6)$$

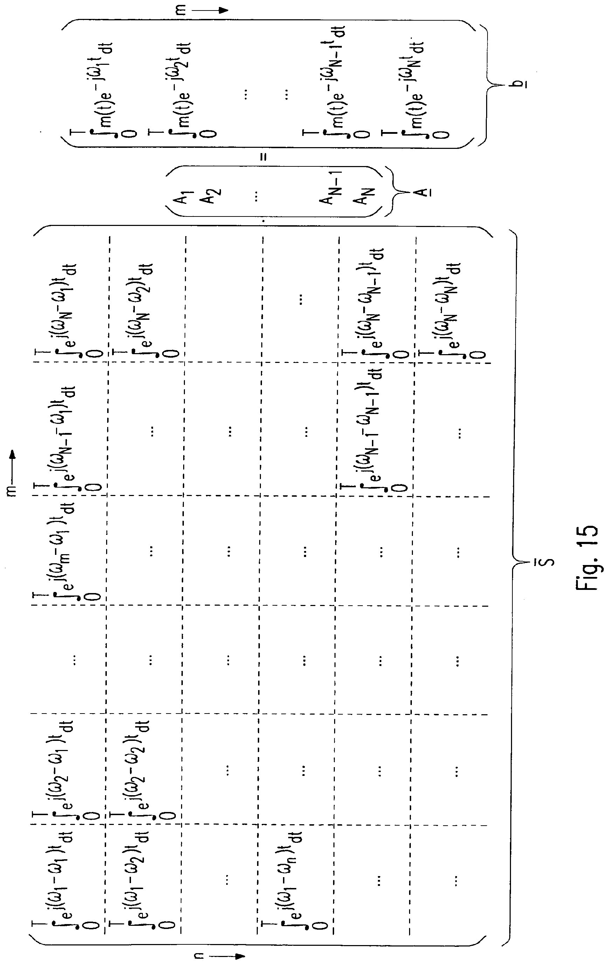

Wird dieser Vorgang der Bildung der ersten Ableitung nach der konjugiert komplexen Spektrallinie $\underline{A}_i$* und die anschliessende Nullsetzung für alle komplexen Spektrallinien $\underline{A}_i$ analog wie in Gleichung (6) durchgeführt, so erhält man ein lineares Gleichungssystem gemäß Fig. 15, die als Gleichung (7) bezeichnet wird.

Dieses lineare Gleichungssystem weist die Dimension N auf, wobei N die Anzahl der komplexen Spektrallinien $\underline{A}_i$ des ideal rauschfreien Signals x(t) darstellt.

Auf der Grundlage der mathematischen Beziehung in Gleichung (7) wird im Folgenden das erfindungsgemäße Verfahren zur Bestimmung der komplexen Spektrallinien $\underline{A}_i$ des Signals x(t) in Fig. 1 beschrieben.

In Verfahrensschritt S10 wird über einen Beobachtungszeitraum T das in einem Signalpfad anstehende rauschbehaftete Signal m(t) gemessen. In der Praxis erfolgt nach der Messung des analogen rauschbehafteten Signals m(t) eine Umwandlung über einen Analog-Digital-Wandler in das digitale Format zur numerischen Weiterverarbeitung des digitalisierten rauschbehafteten Signals m(t) in einer Datenverarbeitungsanlage oder einem Mikrorechner. Für die weitere Beschreibung des erfindungsgemäßen Verfahrens wird aber der Einfachheit halber die analoge Betrachtung beibehalten und im Anschluß daran die notwendigen Anpassungen einer digitalen gegenüber einer analogen Verarbeitung aufgezeigt.

Im nächsten Verfahrensschritt S20 werden die einzelnen Spektralkreisfrequenzen $\omega_i$ der zu ermittelnden komplexen Spektrallinien $\underline{A}_i$ des zum rauschbehafteten Signal m(t) gehörigen ideal rauschfreien Signal x(t) ermittelt. Sind diese Spektralfrequenzen $\omega_i$. nicht bekannt, so müssen sie mittels geeigneter Verfahren (hier nicht diskutiert) bestimmt werden.

Mit dem über den Beobachtungszeitraum T gemessenen rauschbehafteten Signal m(t) und den einzelnen ermittelten Spektralkreisfrequenzen $\omega_i$ werden im Verfahrensschritt S30 die einzelnen Koeffizienten der Systemmatrix $\overline{S}$ und des Vektors $\underline{b}$ der "rechten Gleichungsseite" des linearen Gleichungssystems nach Gleichung (7) berechnet.

Im abschließenden Verfahrensschritt S40 erfolgt die Lösung des in Verfahrensschritt S30 ermittelten linearen Gleichungssystems. Der Lösungsvektor dieses linearen Gleichungssystems ist der Vektor $\underline{A}$ mit allen gesuchten komplexen Spektrallinien $\underline{A}_i$ als Koeffizienten. Hierzu wird das lineare Gleichungssystem numerisch - beispielsweise mit dem Cholesky-Verfahren - gelöst. Die komplexen Koeffizienten des Lösungsvektors $\underline{A}$ des linearen Gleichungssystems, welche die gesuchten komplexen Spektrallinien $\underline{A}_i$ darstellen, werden in die komplexe Darstellung des Betrags $|\underline{A}_i|$ und der Phase $\varphi_i$ transformiert.

Im Unterschied zur bisher beschriebenen analogen Signalverarbeitung wird bei einer digitalen Verarbeitung der digitalisierten Werte des rauschbehaftetes Signals m(t) in Verfahrensschritt S30 bei der Bestimmung der Koeffizienten des Systemmatrix $\overline{S}$ und des Vektors $\underline{b}$ der "rechten Gleichungsseite" des linearen Gleichungssystems anstelle einer kontinuierlichen Integration eine numerische diskrete Integration durchgeführt.

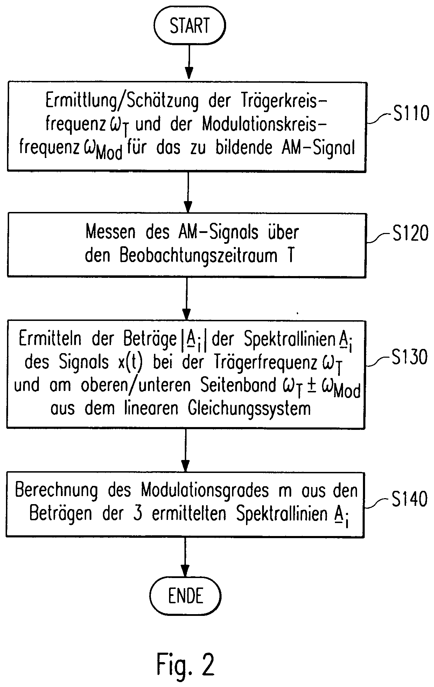

In einem ersten Anwendungsfeld des erfindungsgemäßen Verfahrens zur Ermittlung der komplexen Spektrallinien $\underline{A}_i$ eines ideal rauschfreien Signals x(t) in Fig. 2 wird der Modulationsgrad m eines amplitudenmodulierten HF-, ZF- oder Basisband-Signals $\underline{x}_{AM}(t)$ ermittelt.

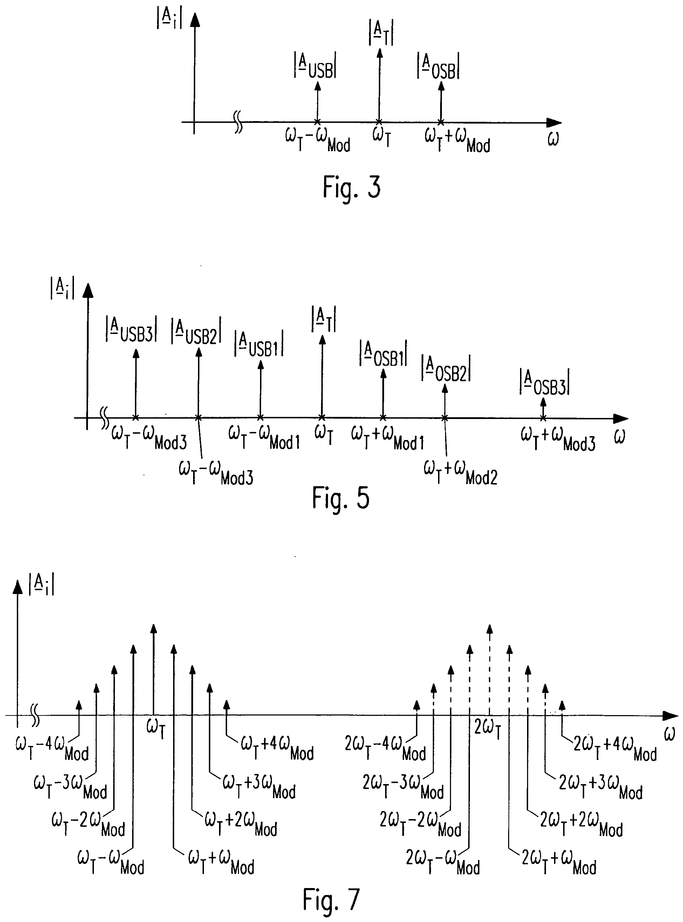

Hierzu werden in Verfahrensschritt S110 die Trägerkreisfrequenz $\omega_T$ des komplexen Trägersignals $\underline{x}_T(t)$, die Modulationskreisfrequenz $\omega_{Mod}$ des komplexen Basisbandsignals $\underline{x}_{BB}(t)$ und damit die Kreisfrequenzen $\omega_T$ und $\omega_T \pm \omega_{Mod}$ am oberen und unteren Seitenband des komplexen amplitudenmodulierten Signals $\underline{x}_{AM}(t)$ gemäß Fig. 3 ermittelt.

Im nächsten Verfahrensschritt S120 wird das komplexe rauschbehaftete amplitudenmodulierte Signal $\underline{m}_{AM}(t)$ über den Beobachtungszeitraum T gemessen.

Im nächsten Verfahrensschritt S130 erfolgt die Bestimmung der Beträge $|\underline{A}_T|$, $|\underline{A}_{USB}|$ und $|\underline{A}_{OSB}|$ der komplexen Spektrallinien $\underline{A}_T$, $\underline{A}_{USB}$ und $\underline{A}_{OSB}$ des komplexen amplitudenmodulierten Signals $\underline{x}_{AM}(t)$ bei der Trägerkreisfrequenz $\omega_T$ und am unteren und oberen Seitenband bei den Spektralkreisfrequenzen $\omega_T \pm \omega_{Mod}$ durch Aufstellung des linearen Gleichungssystems entsprechend Gleichung (7) und Bestimmung des Lösungsvektors des linearen Gleichungssystems, der die einzelnen Spektrallinien $\underline{A}_T$, $\underline{A}_{USB}$ und $\underline{A}_{OSB}$ enthält. In diesem Fall ist die Dimension N des linearen Gleichungssystems gleich drei.

Aus den Beträgen $|\underline{A}_T|$, $|\underline{A}_{USB}|$ und $|\underline{A}_{OSB}|$ wird in Verfahrensschritt S140 gemäß Gleichung (8) der Modulationsgrad m des amplitudenmodulierten Signals $\underline{x}_{AM}(t)$ berechnet.

$$m \;=\; \frac{\left|\underline{A}_{OSB}\right| + \left|\underline{A}_{USB}\right|}{\left|\underline{A}_T\right|} \qquad (8)$$

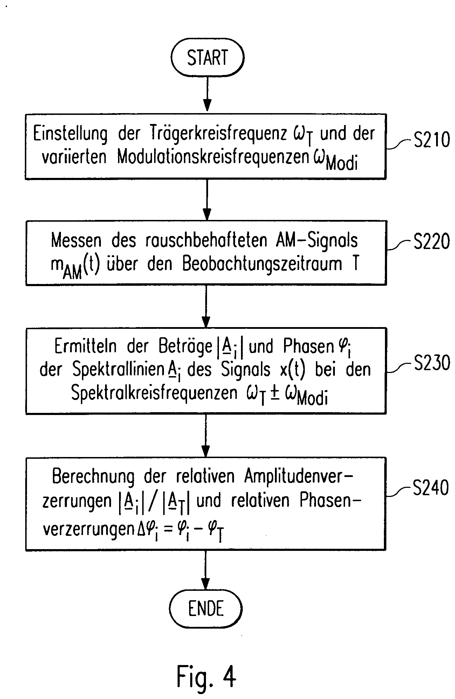

In einem zweiten Anwendungsfeld des erfindungsgemäßen Verfahrens zur Ermittlung der komplexen Spektrallinien $\underline{A}_i$ eines ideal rauschfreien Signals x(t) in Fig. 4 wird die relative Amplitudenverzerrung $|\underline{A}_i|/|\underline{A}_T|$ und die relative Phasenverzerrung $e^{j\Delta\varphi i}=e^{j(\varphi i-\varphi T)}$ ermittelt.

In Verfahrensschritt S210 werden die Trägerkreisfrequenz $\omega_T$ des Trägersignals $\underline{x}_T(t)$ sowie die einzelnen zu variierenden Modulationskreisfrequenzen $\omega_{Modi}$ des Basisbandsignals $\underline{x}_{BB}(t)$ eingestellt.

Im darauffolgenden Verfahrensschritt S220 werden für die Trägerkreisfrequenz $\omega_T$ und die jeweils variierten Modulationskreisfrequenzen $\omega_{Modi}$ des Basisbandsignals $\underline{x}_{BB}(t)$ das jeweilige rauschbehaftete amplitudenmodulierte Signal $\underline{m}_{AM}(t)$ über den Bezugszeitraum T gemessen.

Für jede eingestellte Modulationskreisfrequenz $\omega_{Modi}$ und jedes damit zusammenhängende rauschbehaftete amplitudenmodulierte Signal $\underline{m}_{AM}(t)$ werden im Verfahrensschritt S230 die Beträge $|\underline{A}_i|$ und Phasen $e^{j\varphi i}$ der komplexen Spektrallinien $\underline{A}_i$ des amplitudenmodulierten ideal rauschfreien Signals $\underline{x}_{AM}(t)$ zu allen Spektralkreisfrequenzen $\omega_T\pm\omega_{Modi}$ und zur Trägerkreisfrequenz $\omega_T$ durch Aufstellung des linearen Gleichungssystems entsprechend Gleichung (7) und Bestimmung des Lösungsvektors des linearen Gleichungssystems, der jeweils die einzelnen Spektrallinien $\underline{A}_T$, $\underline{A}_{OSBi}$ und $\underline{A}_{USBi}$ gemäß Fig. 5 enthält, berechnet.

Im abschließenden Verfahrensschritt S240 erfolgt die Berechnung der einzelnen relativen Amplitudenverzerrungen $|\underline{A}_{OSBi}|/|\underline{A}_T|$ bzw. $|\underline{A}_{USBi}|/|\underline{A}_T|$ des rauschfreien amplitudenmodulierten Signals $\underline{x}_{AM}(t)$ zu den einzelnen Spektralkreisfrequenzen $\omega_T+\omega_{Modi}/\omega_T$ bzw. $\omega_T-\omega_{Modi}/\omega_T$ gemäß Gleichung (9).

$$\frac{|\underline{A}_i|}{|\underline{A}_T|} = \frac{|\underline{A}_{OSBi}|}{|\underline{A}_T|} = \frac{|\underline{A}(\omega_T+\omega_{Modi})|}{|\underline{A}(\omega_T)|} \qquad \text{für } \omega > \omega_\tau$$

$$= \frac{|\underline{A}_{USBi}|}{|\underline{A}_T|} = \frac{|\underline{A}(\omega_T-\omega_{Modi})|}{|\underline{A}(\omega_T)|} \qquad \text{für } \omega < \omega_\tau \qquad (9)$$

Die Berechnung der einzelnen relativen Phasenverzerrungen $e^{j\Delta\varphi i}=e^{j(\varphi OSBi-\varphi T)}$ bzw. $e^{j\Delta\omega i}=e^{j(\varphi USBi-\varphi T)}$ des ideal rauschfreien amplitudenmodulierten Signals $\underline{x}_{AM}(t)$ zu den einzelnen Spektralkreisfrequenzen $\omega_T+\omega_{Modi}$, bzw. $\omega_T-\omega_{Modi}$ und zur Trägerkreisfrequenz $\omega_T$ wird in Verfahrensschritt S240 gemäß Gleichung (10) durchgeführt.

$$e^{j\Delta\varphi_i} = e^{j(\varphi_i-\varphi_T)} = e^{j(\varphi_{OSBi}-\varphi_T)} = e^{j(\varphi(\omega_{OSBi})-\varphi(\omega_T))} \qquad \text{für } \omega>\omega_\tau$$

$$= e^{j(\varphi_{USBi}-\varphi_T)} = e^{j(\varphi(\omega_{USBi})-\varphi(\omega_T))} \qquad \text{für } \omega<\omega_\tau$$

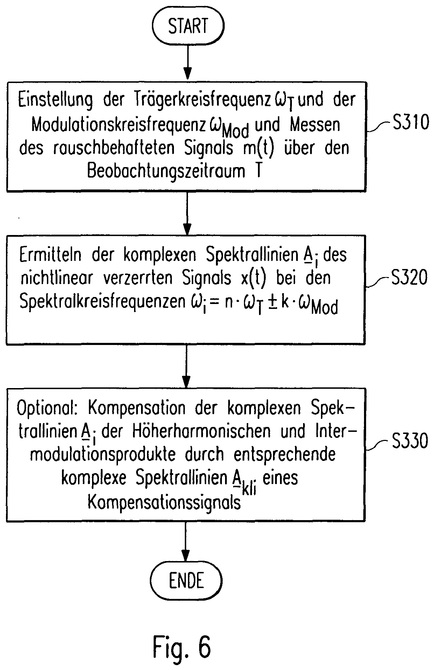

In einem dritten Anwendungsfeld des erfindungsgemäßen Verfahrens zur Ermittlung der komplexen Spektrallinien $\underline{A}_i$ eines rauschbehafteten Signals m(t) in Fig. 6 werden die komplexen Spektrallinien von höherharmonischen Spektralanteilen bzw. von Intermodulationsprodukten eines nichtlinear verzerrten amplitudenmodulierten Signals $\underline{x}_{AM}(t)$ bestimmt und optional durch ein korrespondierendes Kompensationssignal $\underline{k}_1(t)$ kompensiert.

In Verfahrensschritt S310 wird die Trägerkreisfrequenz $\omega_T$ des Trägersignals $\underline{x}_T(t)$ und die Modulationskreisfrequenz $\omega_{Mod}$ des Basisbandsignals $\underline{x}_{BB}(t)$ eingestellt und das nicht-linear verzerrte rauschbehaftete amplitudenmodulierte Signal $\underline{m}_{AM}(t)$ über den Beobachtungszeitraum T gemessen.

Im darauffolgenden Verfahrensschritt S320 wird das lineare Gleichungssystem zur Bestimmung der komplexen Spektrallinien $\underline{A}_i$ des nicht-linear verzerrten ideal rauschfreien amplitudenmodulierten Signals $\underline{x}_{AM}(t)$ unter Berücksichtigung des gemessenen rauschbehafteten amplitudenmodulierten Signals $\underline{m}_{AM}(t)$ und der einzelnen zu den komplexen Spektrallinien $\underline{A}_i$ der Höherharmonischen und der Intermodulationsprodukte gehörigen Spektralkreisfrequenzen $\omega_i$ bestimmt und zur Ermittlung aller komplexen Spektrallinien $\underline{A}_i$ numerisch gelöst. Die Spektralkreisfrequenzen $\omega_i$ der Höherharmonischen und Intermodulationsprodukte des nicht-linear verzerrten ideal rauschfreien amplitudenmodulierten Signals $\underline{x}_{AM}(t)$ ergeben sich gemäß Gleichung (11) aus ganzzahligen Vielfachen - Faktor n in Gleichung (11) - der Trägerkreisfrequenz $\omega_T$ zuzüglich bzw. abzüglich von ganzzahligen Vielfachen - Faktor k in Gleichung (11) - der Modulationskreisfrequenz $\omega_{Mod}$, wie in Fig. 7 dargestellt ist.

$$\omega_i = n * \omega_\tau + k * \omega_{Mod} \qquad (11)$$

Aus den gewonnenen komplexen Spektrallinien der Höherharmonischen bzw. der Intermodulationsprodukte des nicht-linear verzerrten rauschfreien amplitudenmodulierten Signals $\underline{x}_{AM}(t)$ können in einem optionalen Verfahrensschritt S330 die komplexen Spektrallinien $\underline{A}_{k1i}$ eines Kompensationssignals $\underline{k}_1(t)$ ermittelt werden, die dem nicht-linear verzerrten rauschbehafteten amplitudenmodulierten Signal $\underline{m}_{AM}(t)$ zur Kompensation der komplexen Spektrallinien der Höherharmonischen bzw. der Intemodulationsprodukte überlagert werden. Gemäß Gleichung (12) sind die Beträge $|\underline{A}_{k1i}|$ der komplexen Spektrallinien $\underline{A}_{k1i}$ des Kompensationssignals $\underline{k}_1(t)$ bei gleichen Spektralkreisfrequenzen $\omega_i$ identisch zu den Beträgen $|\underline{A}_i|$ der Höherharmonischen bzw. Intermodulationsprodukte. Die Phasen° $\varphi_{k1i}$ der komplexen Spektrallinien $\underline{A}_{k1i}$ des Kompensationssignals $\underline{k}_1(t)$ sind gegenüber den Phasen $\varphi_i$ der Höherharmonischen und Intermodulationsprodukte bei gleichen Spektralkreisfrequenzen $\omega_i$ gemäß Gleichung (13) um 180 Grad phasenverschoben.

$$|\underline{A}_{k1i}| = |\underline{A}_i| \cdot \qquad (12)$$

$$\varphi_{k1i} = \varphi_i + 180° \qquad (13)$$

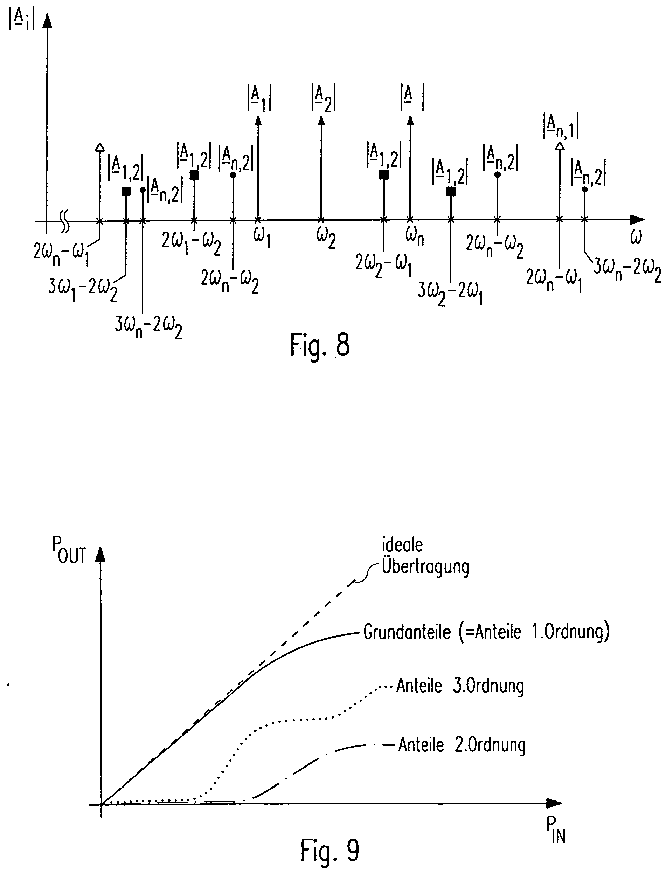

Wird anstelle eines amplitudenmodulierten Signals $x_{AM}(t)$ des dritten Anwendungsfeldes ein N-Ton-Signal $\underline{x}_N(t)$ bestehend aus insgesamt N komplexen Spektrallinien $\underline{A}_1$, $\underline{A}_2$, ...und $\underline{A}_N$ zu den einzelnen Spektralkreisfrequenzen $\omega_1$, $\omega_2$, ... und $\omega_N$ betrachtet, das ebenfalls nicht-linear verzerrt wird, so entsteht das in Fig. 8 dargestellte Spektrum des nicht-linear verzerrten N-Ton Signals $\underline{x}_N(t)$. Das Spektrum enthält sowohl die Spektrallinien der Grundschwingungen $\underline{A}_1$, $\underline{A}_2$, ...und $\underline{A}_N$ als auch die komplexen Spektrallinien $\underline{A}_{i,j}$ der Höherharmonischen und Intermodulationsprodukte, deren Kreisfrequenzkombinationen $\omega_{i,j}$ in Analogie zu Gleichung (11) für den Fall des amplitudenmodulierten Signals $x_{AM}(t)$ sich gemäß Gleichung (12) berechnen.

$$\omega_{i,j} = n * \omega_i + k * \omega_j \qquad (12)$$

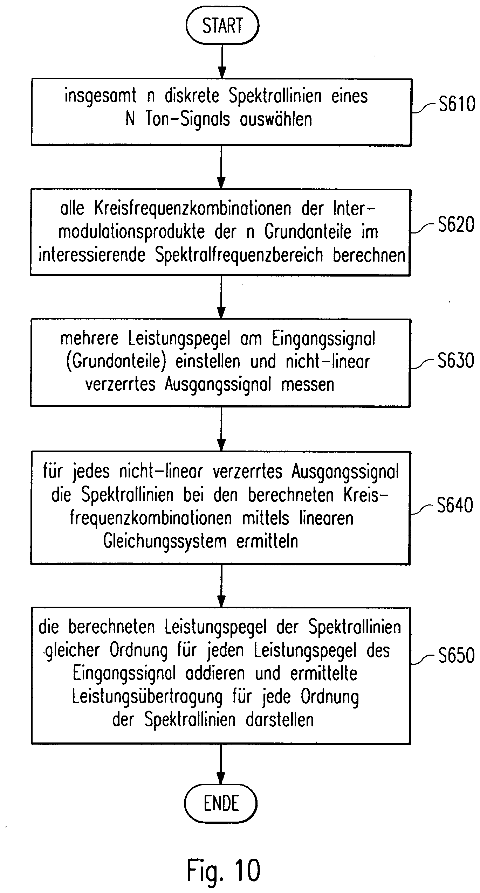

In einem vierten Anwendungsfeld des erfindungsgemäßen Verfahrens zur Ermittlung komplexer Spektrallinien eines N-Ton-Signals $x_N(t)$ wird gemäß Fig. 10 das Übertragungsverhalten $P_{OUT}/P_{IN}$ der einzelnen Spektralanteile gleicher Ordnung bestimmt. Spektralanteile gleicher Ordnung sind die Spektrallinien aller Höherharmonischen und Intermodulationsprodukte des N-Ton-Signals $x_N(t)$, bei denen die Summe der Beträge der beiden ganzzahligen Vorfaktoren n und k der Kreisfrequenzkombinationen $\omega_{i,j}$ in Gleichung (12) den gleichen Wert liefern.

Im ersten Verfahrensschritt S610 des vierten Anwendungsfeldes in Fig. 10 werden von den insgesamt N komplexen Spektrallinien $\underline{A}_i$ des N-Ton-Signals $\underline{x}_N(t)$ n diskrete Spektrallinien $\underline{A}_i$ für die weitere Betrachtung ausgewählt.

Im darauffolgenden Verfahrensschritt S620 werden für alle n ausgewählten Spektrallinien $\underline{A}_i$ alle in einem interessierenden Spektralkreisfrequenzbereich $\Delta\omega_M$ auftretenden Kreisfrequenzkombinationen $\omega_{i,j\,i,j}$ der Höherharmonischen und Intermodulationsprodukte des nicht-linear verzerrten N-Ton-Signals $x_N(t)$ gemäß Gleichung (12) berechnet.

Am Eingang des Übertragungsgliedes, das eine nicht-lineare Verzerrung am N-Ton-Signal $x_N(t)$ bewirkt, wird im Verfahrensschritt S630 ein N-Ton-Signal $x_N(t)$ eingeprägt, dessen Leistungspegel $P_{IN}$ schrittweise verändert wird. Gleichzeitig werden am Ausgang des Übertragungsgliedes die zu den einzelnen N-Ton-Signalen $x_N(t)$ unterschiedlicher Leistungspegel $P_{IN}$ gehörigen Ausgangssignale über einen bestimmten Beobachtungszeitraum T gemessen.

Für jedes somit in Verfahrensschritt S630 gemessene nichtlinar verzerrte Ausgangssignal werden die Beträge $|\underline{A}_{i,j}|$ der komplexen Spektrallinien $\underline{A}_{i,j}$ der zugehörigen Höherharmonischen und Intermodulationsprodukte, deren Kreisfrequenzen $\omega_{i,j}$ im interessierenden Spektralkreisfrequenzbereich $\Delta\omega_M$ liegen, durch numerisches Lösen des linearen Gleichungssystem des erfindungsgemäßen Verfahrens zur Ermittlung von Spektrallinien eines Signal x(t) bestimmt.

Im abschließenden Verfahrensschritt S650 werden die Leistungspegel der im interessierenden Spektralkreisfrequenzbereich $\Delta\omega_M$ befindlichen komplexen Spektrallinien $\underline{A}_{i,j}$ durch Betragsbildung und Quadrierung ermittelt und jeweils bei gleicher Ordnung und gleichem zugehörigen Leistungspegel $P_{IN}$ des N-Ton-Signal $x_N(t)$ am Eingang des Übertragungsgliedes zusammengezählt. Die auf diese Weise jeweils ermittelten Werte stellen die zu einem bestimmten Leistungspegel $P_{IN}$ des N-Ton-Signal $x_N(t)$ am Eingang des Übertragungsgliedes gehörigen Leistungspegel $P_{OUT}$ aller Spektrallinien gleicher Ordnung im interessierenden Spektralkreisfrequenzbereich $\Delta\omega_M$ dar. Sie werden entsprechend Fig. 9 grafisch als Übertragungskennlinien $P_{OUT}/P_{IN}$ der Spektrallinien gleicher Ordnung dargestellt.

Zu erkennen ist in der Grafik in Fig. 9 auch die gestrichelte Kennlinie der idealen Übertragung, bei der entweder keine nicht-lineare Verzerrung auftritt oder die Leistungen aller Spektrallinien - auch der Spektrallinien außerhalb des interessierenden Spektralkreisfrequenzbereich $\Delta\omega_M$ - in Summe berücksichtigt werden.

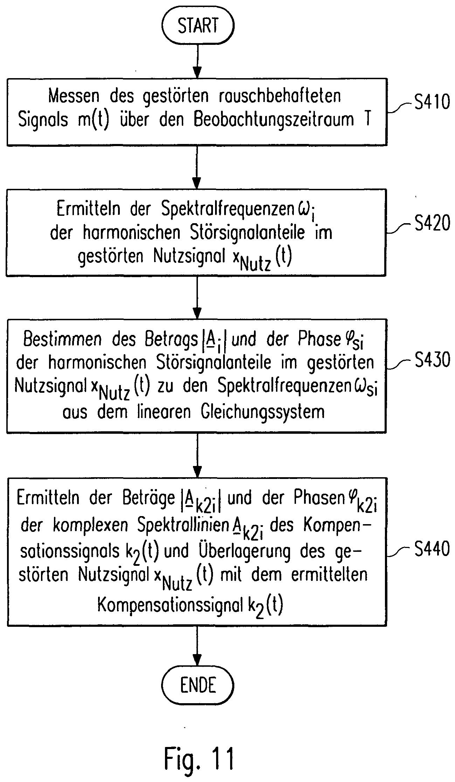

In einem fünften Anwendungsfeld des erfindungsgemäßen Verfahrens zur Ermittlung von komplexen Spektrallinien eines Signals x(t) werden gemäß Fig. 11 die in einem ideal rauschfreien Signal x(t) oder in einem rauschbehafteten Signal m(t) enthaltenen harmonischen Störsignalanteile $A_{si} \cdot e^{j\omega Sit}$ identifiziert und mit einem dazu korrespondierenden Kompensationssignal $\underline{k}_2(t)$ kompensiert. Bei den harmonischen Störsignalen, die dem Nutzsignal $x_{Nutz}(t)$ überlagert sind, kann es sich beispielsweise um Netzbrummen oder um Nebenlinien (Fractional-N-Nebenlinien) in Frequenzsynthesizern handeln.

In Verfahrensschritt S410 wird das mit harmonischen Störsignalanteilen $\underline{x}_{Si}(t)$ gestörte rauschbehaftete Signal m(t) über den Beobachtungszeitraum T gemessen.

Im nächsten Verfahrensschritt S420 werden die Spektralkreisfrequenzen $\omega_{Si}$ der komplexen Spektrallinien $\underline{A}_{Si}$ der Störsignalanteile $\underline{A}_{Si} \cdot e^{j\omega Sit}$ des gestörten Nutzsignals $\underline{x}_{Nutz}(t)$ bestimmt oder durch ein mathematisches Modell geschätzt.

Der nächste Verfahrensschritt S430 beinhaltet die Ermittlung des linearen Gleichungssystem zur Bestimmung der komplexen Spektrallinien $\underline{A}_{Si}$ der Störsignalanteile $\underline{A}_{Si} \cdot e^{j\omega Sit}$, wenn es auf der Basis des gemessenen rauschbehafteten Signals $\underline{m}(t)$ und der Spektralkreisfrequenzen $\omega_{Si}$ der Störsignalanteile ermittelt wird. Durch numerisches Lösen des linearen Gleichungssystems werden die Beträge $|\underline{A}_{Si}|$ und Phasen $\varphi_{Si}$ der einzelnen komplexen Spektrallinien $\underline{A}_{Si}$ der harmonischen Störsignalanteile $\underline{x}_{Si}(t)$ des gestörten Nutzsignals $\underline{x}_{Nutz}(t)$ zu den einzelnen Spektralkreisfrequenzen $\omega_{Si}$ ermittelt.

Im abschließenden Verfahrensschritt S440 erfolgt die Bildung der komplexen Spektrallinien $\underline{A}_{K2i}$ des Kompensationssignals $\underline{k}_2(t)$, mit dem die komplexen Spektrallinien $\underline{A}_{Si}$ der Störsignalanteile $\underline{x}_{Si}(t)$ im gestörten Nutzsignal $\underline{x}_{Nutz}(t)$ kompensiert werden. Die Beträge $|\underline{A}_{K2i}|$ der komplexen Spektrallinien $\underline{A}_{K2i}$ des Kompensationssignals $\underline{k}_2(t)$ bei den einzelnen Spektralkreisfrequenzen $\omega_{K2i}$ sind gemäß Gleichung (15) identisch zu den korrespondierenden Beträgen $|\underline{A}_{Si}|$ der komplexen Spektrallinien $\underline{A}_{Si}$ der harmonischen Störsignalanteile $\underline{x}_{Si}(t)$ im gestörten Nutzsignal $\underline{x}_{Nutz}(t)$. Die Phasen $\varphi_{K2i}$ der komplexen Spektrallinien $\underline{A}_{K2i}$ des Kompensationssignals $\underline{k}_2(t)$ bei den einzelnen Spektralkreisfrequenzen $\omega_{K2i}$ sind gemäß Gleichung (16) um 180 Grad gegenüber den Phasen $\varphi_{Si}$ der komplexen Spektrallinien $\underline{A}_{Si}$ der harmonischen Störsignalanteile $\underline{x}_{Si}(t)$ im gestörten Nutzsignal $\underline{x}_{Nutz}(t)$ phasenverschoben.

$$\left|\underline{A}_{k2i}\right| \;=\; \left|\underline{A}_{si}\right| \qquad\qquad\qquad (15)$$

$$\varphi_{k2i} \;=\; \varphi_{si} \;+\; 180° \qquad\qquad\qquad (16)$$

Das Kompensationssignal $\underline{k}_2(t)$ wird dem gestörten Nutzsignal $\underline{x}_{Nutz}(t)$ additiv überlagert und führt zu einer Kompensation der komplexen Spektrallinien $\underline{A}_{Si}$ der harmonischen Störsignalanteile $\underline{x}_{Si}(t)$ im gestörten Nutzsignal $\underline{x}_{Nutz}(t)$.

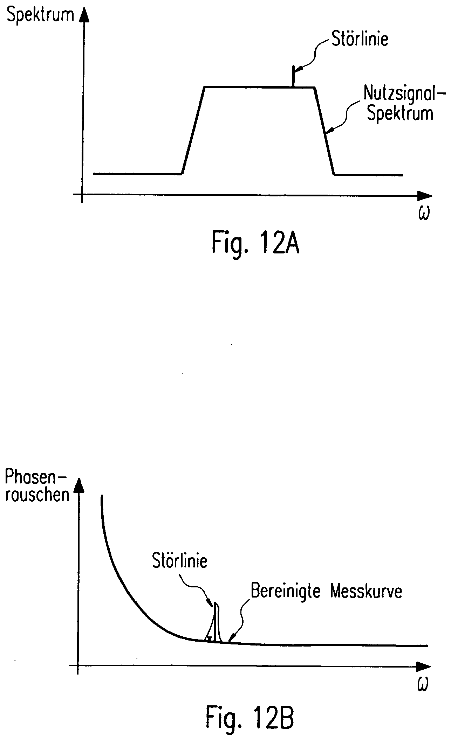

In Fig. 12A ist der Amplitudengang des Frequenzspektrums eines quadraturmodulierten Nutzsignals - beispielsweise eines QPSK-Signals - mit einer Spektrallinie eines dem Nutzsignal überlagerten harmonischen Störsignals $x_s(t)$ dargestellt. Nach Kompensation des gestörten Nutzsignals $x_{Nutz}(t)$ mit einem gemäß Fig. 11 ermittelten Kompensationssignal $\underline{k}_2(t)$ ist der Amplitudengang der Frequenzspektrums des quadraturmodulierten Nutzsignals $x_{Nutz}(t)$ von der Spektrallinie der Störsignals $x_s(t)$ befreit.

Fig. 12B zeigt das Spektrum des Phasenrauschens im logarithmischen Frequenzmaßstab. Auch hier ist die Überlagerung einer Spektrallinie eines dem Nutzsignal überlagerten harmonischen Störsignals $x_s(t)$ zu erkennen, das nach Kompensation mit einem Kompensationssignal $k_2(t)$ aus dem Phasengang verschwindet.

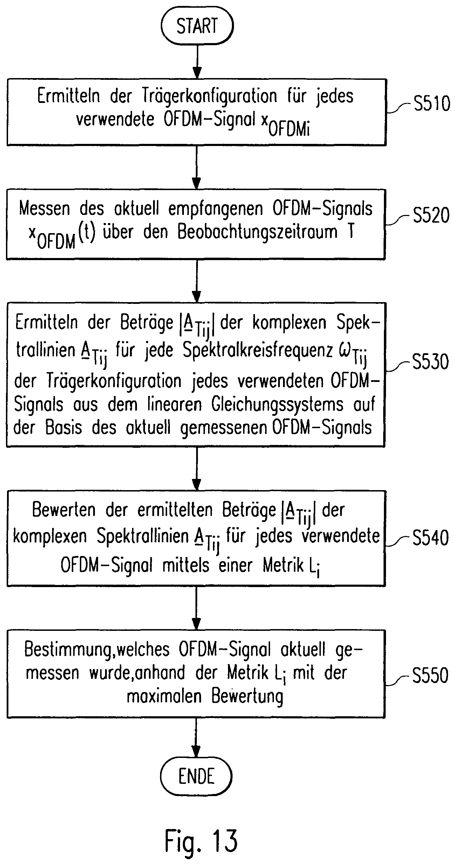

In einem sechsten Anwendungsfeld des erfindungsgemäßen Verfahrens zur Bestimmung der komplexen Spektrallinien eines rauschfreien Signals x(t) wird gemäß Fig. 13 bei einer Signalübertragung mit einem Mehrträgerverfahren - beispielsweise einem OFDM-Verfahren - unter wahlweiser Verwendung verschiedener Trägerkonfigurationen die Trägerkonfiguration des zum Beobachtungszeitraum T empfangenen OFDM-Signals $x_{OFDMi}$ ermittelt.

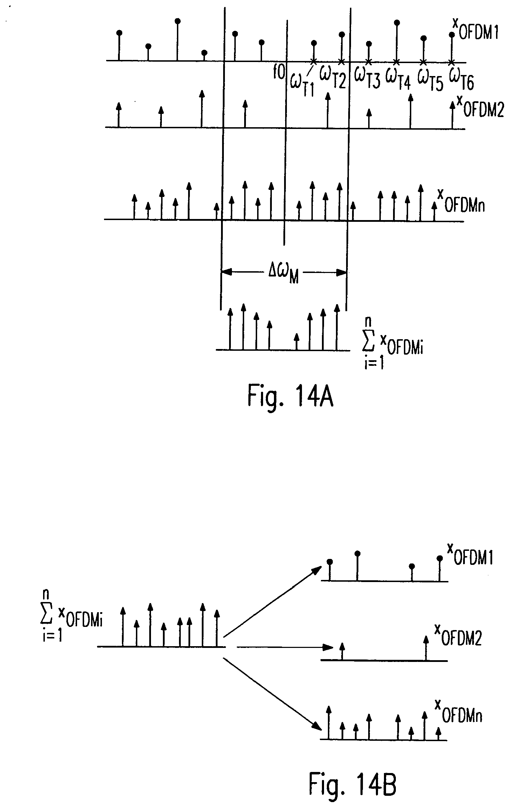

In Verfahrensschritt S510 wird für jedes bei der Übertragung verwendete OFDM-Nutzsignal $x_{OFDMi}$ die dazugehörige Trägerkonfiguration ermittelt. Die Trägerkonfiguration ist durch das Frequenzraster der Trägerkreisfrequenzen $\omega_T$ und durch die trägerkonfigurationspezifische Belegung der einzelnen Trägerkreisfrequenzen $\omega_T$ mit Signalanteilen des OFDM-Signals $x_{OFDMi}$ bestimmt. Hierbei ist zu berücksichtigen, daß die einzelnen Trägerkonfigurationen sich zumindest in einer Trägerkreisfrequenz unterscheiden. Im Hinblick auf eine höhere Sicherheit bei der Unterscheidung zwischen den einzelnen Trägerkonfigurationen sollten die einzelnen Trägerkonfigurationen in mehreren Trägerkreisfrequenzen unterschiedlich ausgelegt sein. Fig. 14A zeigt für verschiedene OFDM-Signale $x_{OFDM1}$, $x_{OFDM2}$, ... , $x_{OFDMn}$ die zugehörigen Trägerkonfigurationen sowie die überlagerten Trägerkonfigurationen aller OFDM-Signale $x_{OFDM1}$ bis $x_{OFDMn}$.

Im nächsten Verfahrensschritt S520 wird das empfangene OFDM-Signal $x_{OFDM}(t)$ über den Beobachtungszeitraum T gemessen.

Für jedes OFDM-Signal $x_{OFDMi}$ wird im Verfahrensschritt S530 auf der Basis des aktuell empfangenen und über den Beobachtungszeitraum T gemessenen OFDM-Signals $x_{OFDM}(t)$ und der spezifischen Trägerkonfiguration, welche die Spektralkreisfrequenzen $\omega_{Tij}$ der einzelnen Träger bestimmt, das lineare Gleichungssystem zur Bestimmung der Beträge $|\underline{A}_{Tij}|$ der komplexen Spektrallinien $\underline{A}_{Tij}$ des gemessenen OFDM-Signals $x_{OFDM}(t)$ zu den Spektralkreisfrequenzen $\omega_{Tij}$ des jeweiligen OFDM-Signals $x_{OFDMi}$ ermittelt. Fig. 14B zeigt bei einem zum Beobachtungszeitraum T empfangenen OFDM-Signal $x_{OFDM}(t)$ die für jedes OFDM-Signal $x_{OFDM1}$, $x_{OFDM2}$, ... , $x_{OFDMn}$ in Verfahrensschritt S530 ermittelten zugehörigen komplexen Spektrallinien $\underline{A}_{T1j}$, $\underline{A}_{T2j}$, ... ,$\underline{A}_{Tnj}$.

Im nächsten Verfahrensschritt S540 werden für jedes verwendete OFDM-Signal $x_{OFDMi}$ und seines trägerkonfigurationsspezifischen Trägerkreisfrequenzrasters die in Verfahrensschritt S530 ermittelten Beträge $|\underline{A}_{Tij}|$ der komplexen Spektrallinien $\underline{A}_{Tij}$ des gemessenen OFDM-Signals $x_{OFDM}(t)$ gemäß Gleichung (17) für die Berechnung einer Metrik $L_i$ verwendet.

$$L_i = \frac{\sum_{j=1}^{ni} \left| \underline{A}_{Tij}(\omega_{Tij}) \right|}{n_i} \qquad (17)$$

Die Größe $n_i$ in Gleichung (17) gibt die jeweilige Anzahl der Trägerkreisfrequenzen $\omega_{Tij}$ des jeweiligen OFDM-Signals $x_{OFDMi}$ an. Entspricht das zum Beobachtungszeitraum T gemessene OFDM-Signal $x_{OFDM}(t)$ dem OFDM-Signal $x_{OFDMi}$, so weisen die komplexen Spektrallinien $\underline{A}_{Tij}$ des gemessenen OFDM-Signals $x_{OFDM}(t)$ bei den einzelnen Trägerkreisfrequenzen $\omega_{Tij}$ Werte auf, die oberhalb der Rauschleistung liegen. Liegt dagegen ein zum Beobachtungszeitraum T gemessenes OFDM-Signal $x_{OFDM}(t)$ vor, daß nicht zum OFDM-Signal $x_{OFDMi}$ gehört, so entsprechen die Spektrallinien $\underline{A}_{Tij}$ des gemessenen OFDM-Signals $x_{OFDM}(t)$ bei den einzelnen Trägerkreisfrequenzen $\omega_{Tij}$ nur den Signalwerten der Rauschleistung. Die entsprechend ermittelte Metrik $L_i$ weist demnach einen niedrigeren Wert auf.

Im abschließenden Verfahrensschritt S550 wird aus allen berechneten Metriken $L_i$ diejenige Metrik $L_i$ identifiziert, die den maximalen Wert aufweist und folglich das OFDM-Signal $x_{OFDMi}$ darstellt, das zum Beobachtungszeitraum T der Übertragung verwendet wurde.

Die Erfindung ist nicht auf die dargestellte Ausführungsform und die vorgestellten Anwendungsfelder beschränkt. Das erfindungsgemäße Verfahren kann in allen Anwendungsfeldern eingesetzt werden, in denen Frequenzspektren mit Spektrallinien vorliegen, deren Beträge und Phasen bei bekannten Spektralfrequenzen der komplexen Spektrallinien bestimmt werden müssen.

**Patentansprüche**

1. Verfahren zur Ermittlung von komplexen Spektrallinien $\underline{A}_i$, die jeweils zu einem mit einer Spektralkreisfrequenz $\omega_i$ behafteten Spektralanteil $\underline{A}_i \cdot e^{j\omega_i t}$ eines ideal rauschfreien Signals $\underline{x}(t)$ gehören, indem über einen Beobachtungszeitraum (T) ein zum ideal rauschfreien Signal $\underline{x}(t)$ korrespondierendes rauschbehaftetes Signal m(t) gemessen wird und durch Minimierung der Fehlerbetragsquadrats $|\underline{m}(t)-\underline{x}(t)|^2$ zwischen dem rauschbehafteten Signal $\underline{m}(t)$ und dem ideal rauschfreien Signal $\underline{x}(t)$ über den Beobachtungszeitraum T mittels des Maximum-Likelihood-Verfahrens ein lineares Gleichungssystem erzeugt wird, dessen numerisch ermittelter Lösungsvektor $\underline{A}$ die komplexen Spektrallinien $\underline{A}_i$ enthalten.

2. Verfahren zur Ermittlung von komplexen Spektrallinien nach Anspruch 1,
**dadurch gekennzeichnet,**
**daß** das lineare Gleichungssystem zur Ermittlung des Lösungsvektors A folgender Matrizengleichung genügt:

$$
\begin{bmatrix}
\int_0^T e^{j(\omega_1-\omega_1)t}dt & \int_0^T e^{j(\omega_2-\omega_1)t}dt & .. & \int_0^T e^{j(\omega_m-\omega_1)t}dt & .. & \int_0^T e^{j(\omega_N-\omega_1)t}dt \\
\int_0^T e^{j(\omega_1-\omega_2)t}dt & \int_0^T e^{j(\omega_2-\omega_2)t}dt & .. & \int_0^T e^{j(\omega_m-\omega_2)t}dt & .. & \int_0^T e^{j(\omega_N-\omega_2)t}dt \\
\vdots & \cdots & .. & \cdots & .. & \cdots \\
\int_0^T e^{j(\omega_1-\omega_n)t}dt & \cdots & .. & \int_0^T e^{j(\omega_m-\omega_n)t}dt & .. & \int_0^T e^{j(\omega_N-\omega_n)t}dt \\
\vdots & \cdots & .. & \cdots & .. & \cdots \\
\int_0^T e^{j(\omega_1-\omega_N)t}dt & \cdots & .. & \int_0^T e^{j(\omega_m-\omega_N)t}dt & .. & \int_0^T e^{j(\omega_N-\omega_N)t}dt
\end{bmatrix}
\cdot
\begin{bmatrix}
\underline{A}_1 \\
\underline{A}_2 \\
\vdots \\
\underline{A}_m \\
\vdots \\
A_N
\end{bmatrix}
=
\begin{bmatrix}
\int_0^T \underline{m}(t)e^{-j\omega_1 t}dt \\
\int_0^T \underline{m}(t)e^{-j\omega_2 t}dt \\
\vdots \\
\int_0^T \underline{m}(t)e^{-j\omega_m t}dt \\
\vdots \\
\int_0^T \underline{m}(t)e^{-j\omega_N t}dt
\end{bmatrix}
$$

wobei

$\omega_i$ die Spektralkreisfrequenz des i-ten Spek tralanteils,
$A_i$ die komplexen Spektrallinien des i-ten Spektralanteils,
T der Beobachtungszeitraum und
$\underline{m}(t)$ das rauschbehaftete Signal

bedeuten.

3. Verfahren zur Ermittlung von komplexen Spektrallinien nach Anspruch 1 oder 2,
   **dadurch gekennzeichnet,**
   **daß** das ideal rauschfreie Signal $\underline{x}(t)$ harmonische Nutzsignalanteile $\underline{A_{Nutzi}} \cdot e^{j\omega it}$ und/oder Störsignalanteile $\underline{A_{Si}} \cdot e^{j\omega it}$ enthält.

4. Verfahren zur Ermittlung von komplexen Spektrallinien nach einem der Ansprüche 1 bis 3,
   **dadurch gekennzeichnet,**
   **daß** bei einem als ideal rauschfreies Signal ($\underline{x}(t)$) benutzten amplitudenmodulierten Signal ($\underline{x_{AM}}(t)$) der Modulationsgrad m aus dem Betrag der mit der Spektralkreisfrequenz $\omega_T$ behafteten komplexen Spektrallinie $\underline{A_T}$ des Trägersignals $\underline{x_T}$ und dem Betrag $|\underline{A_{OSB}}|$ der mit der Spektralkreisfrequenz ($\omega_T + \omega_{Mod}$) behafteten komplexen Spektrallinie $\underline{A_{OSB}}$ oder dem Betrag $|\underline{A_{USB}}|$ der mit der Spektralkreisfrequenz ($\omega_T - \omega_{Mod}$) behafteten komplexen Spektrallinie $\underline{A_{USH}}$ des amplitudenmodulierten Signals $\underline{x_{AM}}(t)$ gemäß der Formel

$$m \;=\; \frac{\left|\underline{A_{OSB}}\right| + \left|\underline{A_{USB}}\right|}{\left|\underline{A_T}\right|}$$

ermittelt wird, wobei

$|\underline{A_{OSB}}|$ der Betrag der komplexen Spektrallinie bei der Spektralkreisfrequenz $\omega_T + \omega_{Mod}$,
$|\underline{A_{USB}}|$ der Betrag der komplexen Spektrallinie bei der Spektralkreisfrequenz $\omega_T - \omega_{Mod}$,
$|\underline{A_T}|$ der Betrag der komplexen Spektrallinie bei der Trägerkreisfrequenz $\omega_T$,
$\omega_T$ die Kreisfrequenz des Trägersignals $x_T(t)$ und
$\omega_{Mod}$ die Kreisfrequenz des Basisbandsignals $x_{Mod}(t)$

bedeuten.

5. Verfahren zur Ermittlung von komplexen Spektrallinien nach Anspruch 4,
   **dadurch gekennzeichnet,**
   **daß** sich die relative lineare Amplitudenverzerrung $|A\,\omega_T + \omega_{Modi})|/|A(\omega_T)|$ eines amplitudenmodulierten Signals $\underline{x_{AM}}(t)$ bei jeder Spektralkreisfrequenz $\omega_T + \omega_{Modi}$ in Relation zur Trägerkreisfrequenz $\omega_T$ nach Einstellung der jeweiligen Kreisfrequenz $\omega_{Modi}$ des Basisbandsignals $\underline{x_{BB}}(t)$ und der Trägerkreisfrequenz $\omega_T$ des Trägersignals $\underline{x_T}(t)$ und Ermittlung des Betrags $|\underline{A_{OSBi}}|$ der komplexen Spektrallinie $\underline{A_{OSBi}}$ des amplitudenmodulierten Signals $\underline{x_{AM}}(t)$ bei jeder Spektralkreisfrequenz $\omega_T + \omega_{Modi}$ und des Betrags $|\underline{A_T}|$ der komplexen Spektrallinie $\underline{A_T}$, des Trägersignals $\underline{x_T}(t)$ durch Berechnung gemäß der Formel

$$\left|A(\omega_T + \omega_{Modi})\right| / \left|A(\omega_T)\right| \;=\; \left|\underline{A_{OSBi}}\right| / \underline{A_T}$$

ergibt.

6. Verfahren zur Ermittlung von komplexen Spektrallinien nach Anspruch 4,
   **dadurch gekennzeichnet,**
   **daß** sich die relative lineare Amplitudenverzerrung $|A\omega_T - \omega_{Modi})|/|A(\omega_T)|$ eines amplitudenmodulierten Signals $\underline{x_{AM}}(t)$ bei jeder Spektralkreisfrequenz $\omega_T - \omega_{Modi}$ in Relation zu einer Trägerkreisfrequenz $\omega_T$ nach Einstellung der jeweiligen Kreisfrequenz $\omega_{Modi}$ des Basisbandsignals $\underline{x_{BB}}(t)$ und der Trägerkreisfrequenz $\omega_T$ des Trägersignals $\underline{x_T}(t)$ und Ermittlung des Betrags $|\underline{A_{USBi}}|$ der komplexen Spektrallinie $\underline{A_{USBi}}$ des amplitudenmodulierten Signals $\underline{x_{AM}}(t)$ bei jeder Spektralkreisfrequenz $\omega_T - \omega_{Modi}$ und des Betrags $|\underline{A_T}|$ der komplexen Spektrallinie $\underline{A_T}$ des Trägersignals $\underline{x_T}(t)$ durch Berechnung gemäß der Formel

$$|A(\omega_T - \omega_{Modi})| \quad / \quad |A(\omega_T)| \quad = \quad |\underline{A}_{USBi}| \quad / \quad |\underline{A}_T|$$

ergibt.

**7.** Verfahren zur Ermittlung von komplexen Spektrallinien nach einem der Ansprüche 4 bis 6,
**dadurch gekennzeichnet,**
**daß** sich die relative lineare Phasenverzerrung $e^{j\Delta\varphi}$ eines amplitudenmodulierten Signals $\underline{x}_{AM}(t)$ bei jeder Spektral-kreisfrequenz $\omega_T + \omega_{Modi}$ in Relation zu einer Trägerkreisfrequenz $\omega_T$ nach Einstellung der jeweiligen Kreisfrequenz $\omega_{unmodi}$ des Basisbandsignals $\underline{x}_{BB}(t)$ und der Trägerkreisfrequenz $\omega_T$ des Trägersignals $\underline{x}_T(t)$ und Ermittlung der Phase $e^{j\varphi OSBi}$ der komplexen Spektrallinie $\underline{A}_{OSBi}$ des amplitudenmodulierten Signals $\underline{x}_{AM}(t)$ bei jeder Spektralkreis-frequenz $\omega_T + \omega_{Modi}$ und der Phase $e^{j\varphi T}$ der komplexen Spektrallinie $\underline{A}_T$ des Trägersignals $\underline{x}_T(t)$ bei der Trägerkreis-frequenz $\omega_T$ durch Berechnung gemäß der Formel

$$e^{j\Delta\varphi} = e^{j(\varphi(\omega T + \omega Modi) - \varphi(\omega T))} = e^{j(\varphi OSBi - \varphi T)}$$

ergibt.

**8.** Verfahren zur Ermittlung von komplexen Spektrallinien nach einem der Ansprüche 4 bis 6,
**dadurch gekennzeichnet,**
**daß** sich die relative lineare Phasenverzerrung $e^{j\Delta\varphi}$ eines amplitudenmodulierten Signals $\underline{x}_{AM}(t)$ bei jeder Spektral-kreisfrequenz $\omega_T - \omega_{Modi}$ in Relation zu einer Trägerkreisfrequenz $\omega_T$ nach Einstellung der jeweiligen Kreisfrequenz $\omega_{Modi}$ des Basisbandsignals $\underline{x}_{BB}(t)$ und der Trägerkreisfrequenz $\omega_T$ des Trägersignals $\underline{x}_T(t)$ und Ermittlung der Phase $e^{j\varphi USBi}$ der komplexen Spektrallinie $\underline{A}_{USBi}$ des amplitudenmodulierten Signals $\underline{x}_{AM}(t)$ bei jeder Spektralkreisfrequenz $\omega_T - \omega_{Modi}$ und der Phase $e^{j\varphi T}$ der komplexen Spektrallinie $(\underline{A}_T)$ des Trägersignals $\underline{x}_T(t)$ bei der Trägerkreisfrequenz $\omega_T$ durch Berechnung gemäß der Formel

$$e^{j\Delta\varphi} = e^{j(\varphi(\omega T - \omega Modi) - \varphi(\omega T))} = e^{j(\varphi USBi - \varphi T)}$$

ergibt.

**9.** Verfahren zur Ermittlung von komplexen Spektrallinien nach einem der Ansprüche 1 bis 8,
**dadurch gekennzeichnet,**
**daß** die Beträge $|\underline{A}_i|$ der komplexen Spektrallinien $\underline{A}_i$ von durch nicht-lineare Verzerrung erzeugten Höherharmonischen und Intermodulationsprodukten des rauschbehafteten Signals $\underline{m}(t)$ bei den Spektralkreisfrequenzen $\omega_i$ aus dem linearen Gleichungssystem bei über den Beobachtungszeitraum $T$ gemessenem rauschbehafteten Signal $\underline{m}(t)$ ermittelt werden, wobei die Spektralkreisfrequenzen $\omega_i$ der Höherharmonischen und Intermodulationsprodukte des rauschbehafteten Signals $\underline{m}(t)$ sich gemäß der Formel

$$\omega_i = n * \omega_T + k * \omega_{unmod}$$

ergeben, wobei

> $n, k$ ganzzahlige Faktoren,
> $\omega_T$ die Trägerkreisfrequenz des Tägersignals $\underline{x}_T(t)$ und
> $\omega_{unmod}$ die Kreisfrequenz des unmodulierten Basisbandsignals $\underline{x}_{BB}(t)$

bedeuten.

**10.** Verfahren zur Ermittlung von komplexen Spektrallinien nach Anspruch 3,
**dadurch gekennzeichnet,**
**daß** zur Kompensation von Störsignalanteilen $A_{Si} \cdot e^{j\omega Sit}$ im rauschbehafteten Signal $\underline{m}(t)$ die jeweiligen Beträge $|\underline{A}_{Si}|$ und Phasen $\varphi_{Si}$ der Störsignalspektrallinien $\underline{A}_{Si}$ aller Störsignalanteile $\underline{A}_{Si} \cdot e^{j\omega Sit}$ zu den einzelnen Störsignalkreis-

frequenzen $\omega_{Si}$ aus dem linearen Gleichungssystem bei über den Beobachtungszeitraum T gemessenem rausch-behafteten Signal $\underline{m}$(t) ermittelt werden und zum rauschbehafteten Signal $\underline{m}$(t) ein Kompensationssignal $\underline{k}_2$(t) mit Kompensationssignalanteilen $\underline{A}_{K2i} \cdot e^{j\omega K2it}$ hinzuaddiert wird.

**11.** Verfahren zur Ermittlung von komplexen Spektrallinien nach Anspruch 10,
**dadurch gekennzeichnet,**
**daß** die Kompensationssignalkreisfrequenzen $\omega_{K2i}$ der Kompensationssignalanteile $\underline{A}_{K2i} \cdot e^{j\omega K2it}$ des Kompensationssignals $\underline{k}_2$(t) identisch zu den Störsignalkreisfrequenzen $\omega_{Si}$ des rauschbehafteten Signal $\underline{m}$(t) sind.

**12.** Verfahren zur Ermittlung von komplexen Spektrallinien nach Anspruch 10 oder 11,
**dadurch gekennzeichnet,**
**daß** die Beträge $|\underline{A}_{k2i}|$ der Kompensationsspektrallinien $\underline{A}_{K2i}$ der Kompensationssignalanteile $\underline{A}_{K2i} \cdot e^{j\omega K2it}$ des Kompensationssignals $\underline{k}_2$(t) identisch zu den Beträgen $|\underline{A}_{Si}|$ der Störsignalanteile $\underline{A}_{Si} \cdot e^{j\omega Sit}$ des rauschbehafteten Signals $\underline{m}$(t) sind.

**13.** Verfahren zur Ermittlung von komplexen Spektrallinien nach einem der Ansprüche 10 bis 12,
**dadurch gekennzeichnet,**
**daß** die Phasen $\varphi_{K2i}$ der Kompensationsspektrallinien $\underline{A}_{k2i}$ der Kompensationssignalanteile $\underline{A}_{K2i} \cdot e^{j\omega K2it}$ des Kompensationssignals $\underline{k}_2$(t) zu den Phasen $\varphi_{Si}$ der Störsignalspektrallinien $\underline{A}_{Si}$ der Störsignalsignalanteile $\underline{A}_{Si} \cdot e^{j\omega Kit}$ des rauschbehafteten Signals $\underline{m}$(t) um 180° phasenverschoben sind.

**14.** Verfahren zur Ermittlung von komplexen Spektrallinien nach einem der Ansprüche 1 bis 13,
**dadurch gekennzeichnet,**
**daß** zur Unterscheidung, welches von mehreren wahlweise empfangbaren Mehrträgersignalen $x_{OFDM1}$, $x_{OFDM2}, \ldots, x_{OFDMi}, \ldots$, $x_{OFDMn}$ zum Betrachtungszeitraum T empfangen wird, für jedes Mehrträgersignal $x_{OFDM1}, x_{OFDM2}, \ldots, x_{OFDMi}, \ldots, x_{OFDMn}$ die Beträge $|\underline{A}_{Tij}|$ der bei allen insgesamt ni Trägerkreisfrequenzen $\omega_{Tij}$ des jeweiligen Mehrträgersignals $x_{OFDM1}, x_{OFDM2}, \ldots, x_{OFDMi}, \ldots, x_{OFDMn}$ befindlichen oder nichtbefindlichen Trägerspektrallinien $\underline{A}_{Tij}$ aus dem linearen Gleichungssystem bei über den Beobachtungszeitraum T gemessenem rauschbehafteten Signal $\underline{m}$(t) ermittelt werden und jeweils einer Bewertung zugeführt werden.

**15.** Verfahren zur Ermittlung von komplexen Spektrallinien nach Anspruch 14,
**dadurch gekennzeichnet,**
**daß** die Mehrträgersignale $x_{OFDM1}$, $x_{OFDM2}$, $.., x_{OFDMi}, \ldots$, $x_{OFDMn}$ OFDM-Signale sind.

**16.** Verfahren zur Ermittlung von komplexen Spektrallinien nach Anspruch 14 oder 15,
**dadurch gekennzeichnet,**
**daß** nur die Beträge $|\underline{A}_{Tij}|$ der innerhalb eines zu betrachtenden Kreisfrequenzbereiches $\Delta\omega_M$ befindlichen Trägerspektrallinien $\underline{A}_{Tij}$ des jeweiligen Mehrträgersignals $x_{OFDM1}, x_{OFDM2}, \ldots, x_{OFDMi}, \ldots, x_{OFDMn}$ berücksichtigt werden.

**17.** Verfahren zur Ermittlung von komplexen Spektrallinien nach einem der Ansprüche 14 bis 16,
**dadurch gekennzeichnet,**
**daß** die für jedes Mehrträgersignal $x_{OFDM1}, x_{OFDM2}, \ldots, x_{OFDMi}, \ldots, x_{OFDMn}$ durchzuführende Bewertung die Berechnung einer Metrik $L_i$ beinhaltet, die sich aus der Formel

$$L_i = \frac{\sum_{j=1}^{ni} |\underline{A}_{Tij}(\omega_{Tij})|}{n_i}$$

ergibt.

**18.** Verfahren zur Ermittlung von komplexen Spektrallinien nach Anspruch 17,
**dadurch gekennzeichnet,**
**daß** entschieden wird, daß dasjenige Mehrträgersignal $x_{ODM1}, x_{OFDM2}, \ldots, x_{OFDMi}, \ldots, x_{OFDMn}$ zum Betrachtungszeitraum T innerhalb des zu betrachtenden Kreisfrequenzbereiches $\Delta\omega_M$ empfangen wird, dessen Metrik ($L_i$) maximal ist.

**19.** Digitales Speichermedium mit elektronisch auslesbaren Steuersignalen, die so mit einem programmierbaren Computer oder digitalen Signalprozessor zusammenwirken können, daß das Verfahren nach einem der Ansprüche 1 bis 18 ausgeführt wird.

20. Computerprogramm-Produkt mit auf einem maschinenlesbaren Träger gespeicherten Programmcode-Mitteln, um alle Schritte gemäß einem der Ansprüche 1 bis 18 durchführen zu können, wenn das Programm auf einem Computer oder einem digitalen Signalprozessor ausgeführt wird.

21. Computerprogramm mit Programmcode-Mitteln, um alle Schritte gemäß einem der Ansprüche 1 bis 18 durchführen zu können, wenn das Programm auf einem Computer oder einem digitalen Signalprozessor ausgeführt wird.

22. Computerprogramm mit Programmcode-Mitteln, um alle Schritte gemäß einem der Ansprüche 1 bis 18 durchführen zu können, wenn das Programm auf einem maschinenlesbaren Datenträger gespeichert ist.

**Claims**

1. Method for determining complex spectral lines $\underline{A}_i$, each belonging to a spectral component $\underline{A}_i \cdot e^{j\omega_i t}$ having a spectral angular frequency $\omega_i$ of an ideal noise-free signal $\underline{x}(t)$, in which a noisy signal $\underline{m}(t)$ corresponding to the ideal noise-free signal $\underline{x}(t)$ is measured over an observation time (T) and a system of linear equations is produced by minimizing the mean square error $|\underline{m}(t)-\underline{x}(t)|^2$ between the noisy signal $\underline{m}(t)$ and the ideal noise-free signal $\underline{x}(t)$ over the observation time (T) by means of the maximum-likelihood method, whose numerically determined solution vector $\underline{A}$ contains the complex spectral lines $\underline{A}_i$.

2. Method for determining complex spectral lines according to claim 1,
   **characterised in that**
   the system of linear equations for determining the solution vector $\underline{A}$ satisfies the following matrix equation:

$$
\begin{bmatrix}
\int\limits_0^T e^{j(\omega_1-\omega_1)t}dt & \int\limits_0^T e^{j(\omega_2-\omega_1)t}dt & .. & \int\limits_0^T e^{j(\omega_m-\omega_1)t}dt & .. & \int\limits_0^T e^{j(\omega_N-\omega_1)t}dt \\
\int\limits_0^T e^{j(\omega_1-\omega_2)t}dt & \int\limits_0^T e^{j(\omega_2-\omega_2)t}dt & .. & \int\limits_0^T e^{j(\omega_m-\omega_2)t}dt & .. & \int\limits_0^T e^{j(\omega_N-\omega_2)t}dt \\
\vdots & \cdots & .. & \cdots & .. & \cdots \\
\int\limits_0^T e^{j(\omega_1-\omega_n)t}dt & \cdots & .. & \int\limits_0^T e^{j(\omega_m-\omega_n)t}dt & .. & \int\limits_0^T e^{j(\omega_N-\omega_n)t}dt \\
\vdots & \cdots & .. & \cdots & .. & \cdots \\
\int\limits_0^T e^{j(\omega_1-\omega_N)t}dt & \cdots & .. & \int\limits_0^T e^{j(\omega_m-\omega_N)t}dt & .. & \int\limits_0^T e^{j(\omega_N-\omega_N)t}dt
\end{bmatrix}
\cdot
\begin{bmatrix}
\underline{A}_1 \\
\underline{A}_2 \\
\vdots \\
\underline{A}_m \\
\vdots \\
\underline{A}_N
\end{bmatrix}
=
$$

$$
\begin{bmatrix}
\int\limits_0^T \underline{m}(t)e^{-j\omega_1 t}dt \\
\int\limits_0^T \underline{m}(t)e^{-j\omega_2 t}dt \\
\vdots \\
\int\limits_0^T \underline{m}(t)e^{-j\omega_m t}dt \\
\vdots \\
\int\limits_0^T \underline{m}(t)e^{-j\omega_N t}dt
\end{bmatrix}
$$

in which

$\omega_i$ denotes the spectral angular frequency of the i-th spectral component,

A$_i$ the complex spectral lines of the i-th spectral component,
T the observation time and
$\underline{m}$(t) the noisy signal.

3. Method for determining complex spectral lines according to claim 1 or 2,
**characterised in that**
the ideal noise-free signal $\underline{x}$(t) contains harmonic useful signal components $\underline{A}_{Nutzi} \cdot e^{j\omega it}$ and/or interference signal components $\underline{A}_{Si} \cdot e^{j\omega it}$.

4. Method for determining complex spectral lines according to one of claims 1 to 3,
**characterised in that**
when an amplitude-modulated signal ($\underline{x}_{AM}$(t)) is used as the ideal noise-free signal (x(t)), the degree of modulation m is determined from the magnitude of the complex spectral line $\underline{A}_T$ having the spectral angular frequency $\omega_T$ of the carrier signal $\underline{x}_T$ and the magnitude $|\underline{A}_{OSB}|$ of the complex spectral line $\underline{A}_{OSB}$ having the spectral angular frequency ($\omega_T + \omega_{Mod}$) or the magnitude $|\underline{A}_{USB}|$ of the complex spectral line $\underline{A}_{USB}$ having the spectral angular frequency ($\omega_T - \omega_{Mod}$) of the amplitude-modulated signal $\underline{x}_{AM}$(t) according to the formula

$$m \;=\; \frac{\left|\underline{A}_{OSB}\right| + \left|\underline{A}_{USB}\right|}{\left|\underline{A}_T\right|}$$

in which

$|\underline{A}_{OSB}|$ denotes the magnitude of the complex spectral line at the spectral angular frequency $\omega_T + \omega_{Mod}$,
$|\underline{A}_{USB}|$ the magnitude of the complex spectral line at the spectral angular frequency $\omega_T - \omega_{Mod}$,
$|\underline{A}_T|$ the magnitude of the complex spectral line at the carrier angular frequency $\omega_T$,
$\omega_T$ the angular frequency of the carrier signal $x_T$(t) and
$\omega_{Mod}$ the angular frequency of the base band signal $x_{Mod}$(t).

5. Method for determining complex spectral lines according to claim 4,
**characterised in that**
the relative linear amplitude distortion $|A(\omega_T + \omega_{Modi})|/|A(\omega_T)|$ of an amplitude-modulated signal $\underline{x}_{AM}$(t) at each spectral angular frequency $\omega_T + \omega_{Modi}$ in relation to the carrier angular frequency $\omega_T$ after adjustment of the respective angular frequency $\omega_{Modi}$ of the base band signal $\underline{x}_{BB}$(t) and the carrier angular frequency $\omega_T$ of the carrier signal $\underline{x}_T$(t) and determination of the magnitude $|\underline{A}_{OSBi}|$ of the complex spectral line $\underline{A}_{OSBi}$ of the amplitude-modulated signal $\underline{x}_{AM}$(t) at each spectral angular frequency $\omega_T + \omega_{Modi}$ and of the magnitude $|\underline{A}_T|$ of the complex spectral line $\underline{A}_T$ of the carrier signal $\underline{x}_T$(t) is obtained by calculation according to the formula

$$|A(\omega_T + \omega_{Modi})| \,/\, |A(\omega_T)| \;=\; |\underline{A}_{OSBi}| \,/\, |\underline{A}_T|.$$

6. Method for determining complex spectral lines according to claim 4,
**characterised in that**
the relative linear amplitude distortion $|A(\omega_T - \omega_{Modi})|/|A(\omega_T)|$ of an amplitude-modulated signal $\underline{x}_{AM}$(t) at each spectral angular frequency $\omega_T - \omega_{Modi}$ in relation to a carrier angular frequency $\omega_T$ after adjustment of the respective angular frequency $\omega_{Modi}$ of the base band signal $\underline{x}_{BB}$(t) and the carrier angular frequency $\omega_T$ of the carrier signal $\underline{x}_T$(t) and determination of the magnitude $|\underline{A}_{USBi}|$ of the complex spectral line $\underline{A}_{USBi}$ of the amplitude-modulated signal $\underline{x}_{AM}$(t) at each spectral angular frequency $\omega_T - \omega_{Modi}$ and of the magnitude $|\underline{A}_T|$ of the complex spectral line $\underline{A}_T$ of the carrier signal $\underline{x}_T$(t) is obtained by calculation according to the formula

$$|A(\omega_T - \omega_{Modi})| \,/\, |A(\omega_T)| \;=\; |\underline{A}_{USBi}| \,/\, |\underline{A}_T|.$$

7. Method for determining complex spectral lines according to one of claims 4 to 6,
**characterised in that**
the relative linear phase distortion $e^{j\Delta\varphi}$ of an amplitude-modulated signal $\underline{x}_{AM}$(t) at each spectral angular frequency $\omega_T + \omega_{Modi}$ in relation to a carrier angular frequency $\omega_T$ after adjustment of the respective angular frequency $\omega_{unmodi}$

of the base band signal $\underline{x}_{BB}(t)$ and the carrier angular frequency $\omega_T$ of the carrier signal $\underline{x}_T(t)$ and determination of the phase $e^{j\varphi OBi}$ of the complex spectral line $\underline{A}_{OSBi}$ of the amplitude-modulated signal $\underline{x}_{AM}(t)$ at each spectral angular frequency $\omega_T+\omega_{Modi}$ and the phase $e^{j\varphi T}$ of the complex spectral line $\underline{A}_T$ of the carrier signal $\underline{x}_T(t)$ at the carrier angular frequency $\omega_T$ is obtained by calculation according to the formula

$$e^{j\Delta\varphi} \;=\; e^{j(\varphi(\omega T+\omega Modi)-\varphi(\omega T))} \;=\; e^{j(\varphi OSBi-\varphi T)}.$$

**8.** Method for determining complex spectral lines according to one of claims 4 to 6,
**characterised in that**
the relative linear phase distortion $e^{j\Delta\varphi}$ of an amplitude-modulated signal $\underline{x}_{AM}(t)$ at each spectral angular frequency $\omega_T-\omega_{Modi}$ in relation to a carrier angular frequency $\omega_T$ after adjustment of the respective angular frequency $\omega_{Modi}$ of the base band signal $\underline{x}_{BB}(t)$ and the carrier angular frequency $\omega_T$ of the carrier signal $\underline{x}_T(t)$ and determination of the phase $e^{j\varphi USBi}$ of the complex spectral line $\underline{A}_{USBi}$ of the amplitude-modulated signal $\underline{x}_{AM}(t)$ at each spectral angular frequency $\omega_T-\omega_{Modi}$ and the phase $e^{j\varphi T}$ of the complex spectral line $(\underline{A}_T)$ of the carrier signal $\underline{x}_T(t)$ at the carrier angular frequency $\omega_T$ is obtained by calculation according to the formula

$$e^{j\Delta\varphi} \;=\; e^{j(\varphi(\omega T-\omega Modi)-\varphi(\omega T))} \;=\; e^{j(\varphi USBi-\varphi T)}.$$

**9.** Method for determining complex spectral lines according to one of claims 1 to 8,
**characterised in that**
the magnitudes $|\underline{A}_i|$ of the complex spectral lines $\underline{A}_i$ of higher harmonic and intermodulation products of the noisy signal $\underline{m}(t)$ produced by non-linear distortion at the spectral angular frequencies $\omega_i$ are determined from the linear equation system with the noisy signal $\underline{m}(t)$ measured over the observation time T, the spectral angular frequencies $\omega_i$ of the higher harmonic and intermodulation products of the noisy signal $\underline{m}(t)$ being obtained according to the formula

$$\omega_i \;=\; n \;*\; \omega_T \;+\; k \;*\; \omega_{unmod}$$

in which

    n, k denote integer factors,
    $\omega_T$ the carrier angular frequency of the carrier signal $\underline{x}_T(t)$ and
    $\omega_{unmod}$ the angular frequency of the unmodulated base band signal $\underline{x}_{BB}(t)$.

**10.** Method for determining complex spectral lines according to claim 3,
**characterised in that**
to compensate for interference signal components $A_{Si}\cdot e^{j\omega Sit}$ in the noisy signal $\underline{m}(t)$ the respective magnitudes $|A_{Si}|$ and phases $\varphi_{Si}$ of the interference signal spectral lines $\underline{A}_{Si}$ of all the interference signal components $A_{Si}\cdot e^{j\omega Sit}$ for the individual interference signal angular frequencies $\omega_{Si}$ are determined from the system of linear equations with the noisy signal $\underline{m}(t)$ measured over the observation time T, and a compensation signal $\underline{k}_2(t)$ with compensation signal components $\underline{L}_{K2i}\cdot e^{j\omega K2it}$ is added to the noisy signal $\underline{m}(t)$.

**11.** Method for determining complex spectral lines according to claim 10,
**characterised in that**
the compensation signal angular frequencies $\omega_{K2i}$ of the compensation signal components $A_{K2i}\cdot e^{j\omega K2it}$ of the compensation signal $\underline{k}_2(t)$ are identical to the interference signal angular frequencies $\omega_{Si}$ of the noisy signal $\underline{m}(t)$.

**12.** Method for determining complex spectral lines according to claim 10 or 11,
**characterised in that**
the magnitudes $|A_{k2i}|$ of the compensation spectral lines $A_{k2i}$ of the compensation signal components $A_{K2i}\cdot e^{j\omega K2it}$ of the compensation signal $\underline{k}_2(t)$ are identical to the magnitudes $|\underline{A}_{Si}|$ of the interference signal components $\underline{A}_{Si}\cdot e^{j\omega Sit}$ of the noisy signal $\underline{m}(t)$.

**13.** Method for determining complex spectral lines according to one of claims 10 to 12,
**characterised in that**
the phases $\varphi_{K2i}$ of the compensation spectral lines $\underline{A}_{k2i}$ of the compensation signal components $A_{K2i}\cdot e^{j\omega K2it}$ of the

compensation signal $\underline{k}_2(t)$ are phase-shifted by 180° to the phases $\varphi_{Si}$ of the interference signal spectral lines $\underline{A}_{Si}$ of the interference signal components $\underline{A}_{Si} \cdot e^{j\omega Kit}$ of the noisy signal $\underline{m}(t)$.

**14.** Method for determining complex spectral lines according to one of claims 1 to 13, **characterised in that** to decide which of a plurality of optionally receivable multicarrier signals $X_{OFDM1}, X_{OFDM2}, .., x_{FDMi}, .. , x_{OFDMn}$ is received for the observation time T, for each multicarrier signal $X_{OFDM1}, X_{OFDM2}, .., X_{OFDMi}, .., x_{OFDMn}$ the magnitudes $|\underline{A}_{Tij}|$ of the carrier spectral lines $\underline{A}_{Tij}$ which are to be found or not at all of the total of ni carrier angular frequencies $\omega_{Tij}$ of the respective multicarrier signal $X_{OFDM1}, X_{OFDM2}, .., X_{OFDMi}, .. , x_{OFDMn}$ are determined from the system of linear equations using the noisy signal $\underline{m}(t)$ measured over the observation time T and supplied for evaluation in each case.

**15.** Method for determining complex spectral lines according to claim 14, **characterised in that** the multicarrier signals $X_{OFDM1}, X_{OFDM2}, .., X_{OFDMi}, .., x_{OFDMn}$ are OFDM signals.

**16.** Method for determining complex spectral lines according to claim 14 or 15, **characterised in that** only the magnitudes $|\underline{A}_{Tij}|$ of the carrier spectral lines $\underline{A}_{Tij}$ to be found within an angular frequency range $\Delta\omega_M$ to be observed of the respective multicarrier signal $X_{OFDM1}, X_{OFDM2}, .., x_{OFDMi}, .., x_{OFDMn}$ are taken into account.

**17.** Method for determining complex spectral lines according to one of claims 14 to 16, **characterised in that** the evaluation to be carried out for each multicarrier signal $X_{OFDM1}, X_{OFDM2}, .., X_{OFDMi}, .., x_{OFDMn}$ includes the calculation of a metric $L_i$ which is obtained from the formula

$$L_i \;=\; \frac{\sum\limits_{j=1}^{ni} \left| \underline{A}_{Tij}(\omega_{Tij}) \right|}{n_i} \, .$$

**18.** Method for determining complex spectral lines according to claim 17, **characterised in that** it is decided that the multicarrier signal $X_{OFDM1}, X_{OFDM2}, .., x_{OFDMi}, .., x_{OFDMn}$ having the maximum metric ($L_i$) is received for the observation time T within the angular frequency range $\Delta\omega_M$ to be observed.

**19.** Digital storage medium with control signals which can be read out electronically and cooperate with a programmable computer or digital signal processor so as to implement the method according to one of claims 1 to 18.

**20.** Computer programme product with programme code means stored on a machine-readable storage medium in order to be able to carry out all the steps according to one of claims 1 to 18 when the programme is implemented on a computer or a digital signal processor.

**21.** Computer programme with programme code means in order to be able to carry out all the steps according to one of claims 1 to 18 when the programme is implemented on a computer or a digital signal processor.

**22.** Computer programme with programme code means in order to be able to carry out all the steps according to one of claims 1 to 18 when the programme is stored on a machine-readable data storage medium.

**Revendications**

**1.** Procédé de détermination de raies spectrales complexes $\underline{A}_i$, qui font chacune partie d'une composante spectrale $\underline{A}_i \cdot e^{j\omega it}$, soumise à une fréquence circulaire spectrale $\omega_i$, d'un signal $\underline{x}(t)$ idéalement sans bruit, du fait qu'un signal $\underline{m}(t)$ entaché d'un bruit, correspondant au signal $\underline{x}(t)$ idéalement sans bruit, est mesuré pendant une période d'observation (T), et qu'un système d'équation linéaire, dont le vecteur de solution $\underline{A}$ déterminé numériquement contient les raies spectrales complexes $\underline{A}_i$, est produit par réduction au minimum du carré de montant d'erreur $|\underline{m}(t)-\underline{x}(t)|^2$

entre le signal $\underline{m}$(t) entaché d'un bruit et le signal $\underline{x}$(t) idéalement sans bruit pendant toute la période d'observation T au moyen du procédé de vraisemblance maximale.

2. Procédé de détermination de raies spectrales complexes selon la revendication 1,
   **caractérisé**
   **en ce que** le système d'équation linéaire destiné à déterminer le vecteur de solution $\underline{A}$ satisfait à l'équation matricielle suivante :

$$\begin{bmatrix} \int_0^T e^{j(\omega_1-\omega_1)t}dt & \int_0^T e^{j(\omega_2-\omega_1)t}dt & .. & \int_0^T e^{j(\omega_m-\omega_1)t}dt & .. & \int_0^T e^{j(\omega_N-\omega_1)t}dt \\ \int_0^T e^{j(\omega_1-\omega_2)t}dt & \int_0^T e^{j(\omega_2-\omega_2)t}dt & .. & \int_0^T e^{j(\omega_m-\omega_2)t}dt & .. & \int_0^T e^{j(\omega_N-\omega_2)t}dt \\ \vdots & ... & .. & ... & .. & ... \\ \int_0^T e^{j(\omega_1-\omega_n)t}dt & ... & .. & \int_0^T e^{j(\omega_m-\omega_n)t}dt & .. & \int_0^T e^{j(\omega_N-\omega_n)t}dt \\ \vdots & ... & .. & ... & .. & ... \\ \int_0^T e^{j(\omega_1-\omega_N)t}dt & ... & .. & \int_0^T e^{j(\omega_m-\omega_N)t}dt & .. & \int_0^T e^{j(\omega_N-\omega_N)t}dt \end{bmatrix} \cdot \begin{bmatrix} \underline{A}_1 \\ \underline{A}_2 \\ \vdots \\ \underline{A}_m \\ \vdots \\ \underline{A}_N \end{bmatrix} = \begin{bmatrix} \int_0^T \underline{m}(t)e^{-j\omega_1 t}dt \\ \int_0^T \underline{m}(t)e^{-j\omega_2 t}dt \\ \vdots \\ \int_0^T \underline{m}(t)e^{-j\omega_m t}dt \\ \vdots \\ \int_0^T \underline{m}(t)e^{-j\omega_N t}dt \end{bmatrix}$$

dans laquelle

$\omega_i$ représente la fréquence circulaire spectrale de la i-ème composante spectrale,
$\underline{A}_i$ représente les raies spectrales complexes de la i-ème composante spectrale,
$\overline{T}$ représente la période d'observation et
$\underline{m}$(t) représente le signal entaché d'un bruit.

3. Procédé de détermination de raies spectrales complexes selon la revendication 1 ou 2,
   **caractérisé**
   **en ce que** le signal $\underline{x}$(t) idéalement sans bruit contient des composantes harmoniques de signal utile $\underline{A_{Nutz}}i \cdot e^{j\omega i t}$ et/ou des composantes de signal brouilleur $\underline{A_{Si}} \cdot e^{j\omega i t}$.

4. Procédé de détermination de raies spectrales complexes selon l'une quelconque des revendications 1 à 3,
   **caractérisé**
   **en ce que**, dans le cas d'un signal modulé en amplitude ($\underline{x}_{AM}$(t)) utilisé comme signal ($\underline{x}$(t)) idéalement sans bruit, le degré de modulation m est déterminé à partir du montant de la raie spectrale complexe $\underline{A}_T$, soumise à la fréquence circulaire spectrale $\omega_T$, du signal porteur $\underline{x}_T$ et du montant $|\underline{A}_{OSB}|$ de la raie spectrale complexe $\underline{A}_{OSB}$ soumise à la fréquence circulaire spectrale ($\omega+\omega_{Mod}$) ou du montant $|\underline{A}_{USB}|$ de la raie spectrale complexe $\underline{A}_{USB}$, soumise à la fréquence circulaire spectrale ($\omega_T-\omega_{Mod}$), du signal modulé en amplitude $\underline{x}_{AM}$(t) selon la formule

$$m \;=\; \frac{\left|\underline{A}_{OSB}\right| + \left|\underline{A}_{USB}\right|}{\left|\underline{A}_T\right|}$$

dans laquelle

$|\underline{A}_{OSB}|$ représente le montant de la raie spectrale complexe à la fréquence circulaire spectrale $\omega_T+\omega_{Mod}$,
$|\underline{A}_{USB}|$ représente le montant de la raie spectrale complexe à la fréquence circulaire spectrale $\omega_T-\omega_{Mod}$,
$|\underline{A}_T|$ représente le montant de la raie spectrale complexe à la fréquence circulaire porteuse $\omega_T$,
$\omega_T$ représente la fréquence circulaire du signal porteur $x_T$(t) et
$\omega_{Mod}$ représente la fréquence circulaire du signal de bande de base $x_{Mod}$(t).

5. Procédé de détermination de raies spectrales complexes selon la revendication 4,

**caractérisé**

**en ce que** la distorsion d'amplitude linéaire relative $|A(\omega+\omega_{Modi})|/|A(\omega_T)|$ d'un signal modulé en amplitude $\underline{x}_{AM}(t)$ pour chaque fréquence circulaire spectrale $\omega_T+\omega_{Modi}$ par rapport à la fréquence circulaire porteuse $\omega_T$ après réglage de la fréquence circulaire $\omega_{Modi}$ respective du signal de bande de base $\underline{x}_{BB}(t)$ et de la fréquence circulaire porteuse $\omega_T$ du signal porteur $\underline{x}_T(t)$ et détermination du montant $|\underline{A}_{OSBi}|$ de la raie spectrale complexe $\underline{A}_{OSBi}$ du signal modulé en amplitude $\underline{x}_{AM}(t)$ pour chaque fréquence circulaire spectrale $\omega_T+\omega_{Modi}$ et du montant $|\underline{A}_T|$ de la raie spectrale complexe $\underline{A}_T$ du signal porteur $\underline{x}_T(t)$ est obtenue par calcul selon la formule

$$|A(\omega_T+\omega_{Modi})| \ / \ |A(\omega_T)| \ = \ |\underline{A}_{OSBi}| \ / \ |\underline{A}_T|$$

6. Procédé de détermination de raies spectrales complexes selon la revendication 4,
**caractérisé**
**en ce que** la distorsion d'amplitude linéaire relative $|A(\omega_T-\omega_{Modi})/A(\omega_T)|$ d'un signal modulé en amplitude $\underline{x}_{AM}(t)$ pour chaque fréquence circulaire spectrale $\omega_T-\omega_{Modi}$ par rapport à une fréquence circulaire porteuse $\omega_T$ après réglage de la fréquence circulaire $\omega_{Modi}$ respective du signal de bande de base $\underline{x}_{BB}(t)$ et de la fréquence circulaire porteuse $\omega_T$ du signal porteur $\underline{x}_T(t)$ et détermination du montant $|A_{USBi}|$ de la raie spectrale complexe $\underline{A}_{USBi}$ du signal modulé en amplitude $\underline{x}_{AM}(t)$ pour chaque fréquence circulaire spectrale $\omega_T-\omega_{Modi}$ et du montant $|\underline{A}_T|$ de la raie spectrale complexe $\underline{A}_T$ du signal porteur $\underline{x}_T(t)$ est obtenue par calcul selon la formule

$$|A(\omega_T-\omega_{Modi})| \ / \ |A(\omega_T)| \ = \ |\underline{A}_{USBi}| \ / \ |\underline{A}_T|$$

7. Procédé de détermination de raies spectrales complexes selon l'une quelconque des revendications 4 à 6,
**caractérisé**
**en ce que** la distorsion d'amplitude linéaire relative $e^{j\Delta\varphi}$ d'un signal modulé en amplitude $\underline{x}_{AM}(t)$ pour chaque fréquence circulaire spectrale $\omega_T+\omega_{Modi}$ par rapport à une fréquence circulaire porteuse $\omega_T$ après réglage de la fréquence circulaire $\omega_{unmodi}$ respective du signal de bande de base $\underline{x}_{BB}(t)$ et de la fréquence circulaire porteuse $\omega_T$ du signal porteur $\underline{x}_T(t)$ et détermination de la phase $e^{j\varphi OSBi}$ de la raie spectrale complexe $\underline{A}_{OSBi}$ du signal modulé en amplitude $\underline{x}_{AM}(t)$ pour chaque fréquence circulaire spectrale $\omega_T+\omega_{Modi}$ et de la phase $e^{j\varphi T}$ de la raie spectrale complexe $\underline{A}_T$ du signal porteur $\underline{x}_T(t)$ à la fréquence circulaire porteuse $\omega_T$ est obtenue par calcul selon la formule

$$e^{j\Delta\varphi} \ = \ e^{j(\varphi(\omega T+\omega Modi)-\varphi(\omega T))} \ = \ e^{j(\varphi OSBi-\varphi T)}$$

8. Procédé de détermination de raies spectrales complexes selon l'une quelconque des revendications 4 à 6,
**caractérisé**
**en ce que** la distorsion d'amplitude linéaire relative $e^{j\Delta\varphi}$ d'un signal modulé en amplitude $\underline{x}_{AM}(t)$ pour chaque fréquence circulaire spectrale $\omega_T-\omega_{Modi}$ par rapport à une fréquence circulaire porteuse $\omega_T$ après réglage de la fréquence circulaire $\omega_{modi}$ respective du signal de bande de base $\underline{x}_{BB}(t)$ et de la fréquence circulaire porteuse $\omega_T$ du signal porteur $\underline{x}_T(t)$ et détermination de la phase $e^{j\varphi USBi}$ de la raie spectrale complexe $\underline{A}_{USBi}$ du signal modulé en amplitude $\underline{x}_{AM}(t)$ pour chaque fréquence circulaire spectrale $\omega_T-\omega_{Modi}$ et de la phase $e^{j\varphi T}$ de la raie spectrale complexe $(\underline{A}_T)$ du signal porteur $\underline{x}_T(t)$ à la fréquence circulaire porteuse $\omega_T$ est obtenue par calcul selon la formule

$$e^{j\Delta\varphi} \ = \ e^{j(\varphi(\omega T-\omega Modi)-\varphi(\omega T))} \ = \ e^{j(\varphi USBi-\varphi T)}$$

9. Procédé de détermination de raies spectrales complexes selon l'une quelconque des revendications 1 à 8,
**caractérisé**
**en ce que** les montants $|\underline{A}_i|$ des raies spectrales complexes $\underline{A}_i$ d'harmoniques supérieurs générés par une distorsion non linéaire et les produits d'intermodulation du signal m(t) entaché d'un bruit aux fréquences circulaires spectrales $\omega_i$ sont déterminés à partir du système d'équation linéaire lorsque le signal $\underline{m}(t)$ entaché d'un bruit est mesuré pendant la période d'observation T, les fréquences circulaires spectrales $\omega_i$ des harmoniques supérieurs et les produits d'intermodulation du signal $\underline{m}(t)$ entaché d'un bruit étant obtenus selon la formule

$$\omega_i \ = \ n \ * \ \omega_T \ + \ k \ * \ \omega_{unmod}$$

dans laquelle

n, k représente des facteurs entiers,

$\omega_T$ représente la fréquence circulaire porteuse du signal porteur $\underline{x}_T(t)$ et

$\omega_{unmod}$ représente la fréquence circulaire du signal de bande de base $\underline{x}_{BB}(t)$ non modulé.

**10.** Procédé de détermination de raies spectrales complexes selon la revendication 3, **caractérisé**

**en ce que** pour la compensation de composantes de signal brouilleur $A_{Si} \cdot e^{j\omega Sit}$ dans le signal $\underline{m}(t)$ entaché d'un bruit, les montants $|A_{Si}|$ respectifs et les phases $\varphi_{Si}$ des raies spectrales de signal brouilleur $\underline{A}_{Si}$ de toutes les composantes de signal brouilleur $A_{Si} \cdot e^{j\omega Sit}$ sont déterminés aux différentes fréquences circulaires de signal brouilleur $\omega_{Si}$ à partir du système d'équation linéaire lorsque le signal $\underline{m}(t)$ entaché d'un bruit est mesuré pendant la période d'observation T et un signal de compensation $\underline{k}_2(t)$ présentant des composantes de signal de compensation $A_{K2i} \cdot e^{j\omega K2it}$ est ajouté au signal $\underline{m}(t)$ entaché d'un bruit.

**11.** Procédé de détermination de raies spectrales complexes selon la revendication 10, **caractérisé**

**en ce que** les fréquences circulaires de signal de compensation $\omega_{K2i}$ des composantes de signal de compensation $A_{K2i} \cdot e^{j\omega K2it}$ du signal de compensation $\underline{k}_2(t)$ sont identiques aux fréquences circulaires de signal brouilleur $\omega_{Si}$ du signal $\underline{m}(t)$ entaché d'un bruit.

**12.** Procédé de détermination de raies spectrales complexes selon la revendication 10 ou 11, **caractérisé**

**en ce que** les montants $|A_{K2i}|$ des raies spectrales de compensation $A_{K2i}$ des composantes de signal de compensation $A_{K2i} \cdot e^{j\omega K2it}$ du signal de compensation $\underline{k}_2(t)$ sont identiques aux montants $|A_{Si}|$ des composantes de signal brouilleur $\underline{A}_{Si} \cdot e^{j\omega Sit}$ du signal $\underline{m}(t)$ entaché d'un bruit.

**13.** Procédé de détermination de raies spectrales complexes selon l'une quelconque des revendications 10 à 12, **caractérisé**

**en ce que** les phases $\varphi_{K2i}$ des raies spectrales de compensation $A_{K2i}$ des composantes de signal de compensation $A_{K2i} \cdot e^{j\omega K2it}$ du signal de compensation $\underline{k}_2(t)$ sont déphasées de 180° par rapport aux phases $\varphi_{Si}$ des raies spectrales de signal brouilleur $\underline{A}_{Si}$ des composantes de signal brouilleur $\underline{A}_{Si} \cdot e^{j\omega Kit}$ du signal $\underline{m}(t)$ entaché d'un bruit.

**14.** Procédé de détermination de raies spectrales complexes selon l'une quelconque des revendications 1 à 13, **caractérisé**

**en ce que** pour distinguer quel signal est reçu parmi plusieurs signaux à porteuses multiples $X_{OFDM1}, X_{OFDM2}, \cdots, x_{FDMi}, \cdots, x_{OFDMn}$ pouvant être reçus sélectivement à la période d'observation T, pour chaque signal à porteuses multiples $X_{OFDM1}, X_{OFDM2}, \cdots, X_{OFDMi}, \cdots, X_{OFDMn}$, les montants $|\underline{A}_{Tij}|$ des raies spectrales porteuses $\underline{A}_{Tij}$ existantes ou non existantes pour toutes les ni fréquences circulaires porteuses $\omega_{TIJ}$ du signal à porteuses multiples $X_{OFDM1}, X_{OFDM2}, \cdots, x_{FDMi}, \cdots, x_{OFDMn}$ respectif sont déterminés à partir du système d'équation linéaire lorsque le signal $\underline{m}(t)$ entaché d'un bruit est mesuré pendant la période d'observation T et amenés respectivement à une évaluation.

**15.** Procédé de détermination de raies spectrales complexes selon la revendication 14, **caractérisé**

**en ce que** les signaux à porteuses multiples $X_{OFDM1}, X_{OFDM2}, \cdots, x_{OFDMi}, \cdots, x_{OFDMn}$ sont des signaux OFDM.

**16.** Procédé de détermination de raies spectrales complexes selon la revendication 14 ou 15, **caractérisé**

**en ce que** seuls les montants $|\underline{A}_{Tij}|$ des raies spectrales porteuses $\underline{A}_{Tij}$ situées à l'intérieur d'une plage de fréquences circulaires $\Delta\omega_M$ à prendre en considération du signal à porteuses multiples $X_{OFDM1}, X_{OFDM2}, \cdots, x_{FDMi}, \cdots, x_{OFDMn}$ respectif sont pris en compte.

**17.** Procédé de détermination de raies spectrales complexes selon l'une quelconque des revendications 14 à 16, **caractérisé**

**en ce que** l'évaluation à mettre en oeuvre pour chaque signal à porteuses multiples $x_{OFDM1}, x_{FDM2}, \cdots, x_{FDMi}, \cdots, x_{OFDMn}$ comporte le calcul d'une métrique $L_i$, qui est obtenue à partir de la formule

$$L_i = \frac{\sum_{j=1}^{ni}\left|\underline{A}_{Tij}(\omega_{Tij})\right|}{n_i}$$

**18.** Procédé de détermination de raies spectrales complexes selon la revendication 17,
**caractérisé**
**en ce qu'**il est décidé que le signal à porteuses multiples $x_{OFDM1}$, $x_{OFDM2}$,.., $x_{OFDMi}$, .., $x_{OFDMn}$ qui est reçu à la période d'observation T à l'intérieur de la plage de fréquences circulaires $\Delta\omega_M$ à prendre en considération est celui dont la métrique ($L_i$) est maximale.

**19.** Support d'enregistrement numérique à signaux de commande pouvant être lus de manière électronique, qui peuvent coopérer avec un ordinateur programmable ou un processeur de signaux numériques, de sorte que le procédé selon l'une quelconque des revendications 1 à 18 est réalisé.

**20.** Produit-programme informatique comprenant des moyens formant code de programme mis en mémoire sur un support lisible par ordinateur, afin de pouvoir mettre en oeuvre toutes les étapes selon l'une quelconque des revendications 1 à 18, lorsque le programme est exécuté sur un ordinateur ou un processeur de signaux numériques.

**21.** Programme informatique comprenant des moyens formant code de programme, afin de pouvoir mettre en oeuvre toutes les étapes selon l'une quelconque des revendications 1 à 18, lorsque le programme est exécuté sur un ordinateur ou un processeur de signaux numériques.

**22.** Programme informatique comprenant des moyens formant code de programme, afin de pouvoir mettre en oeuvre toutes les étapes selon l'une quelconque des revendications 1 à 18, lorsque le programme est mis en mémoire sur un support de données lisible par ordinateur.

START

Messen eines rauschbehafteten Signals $m(t)$ über den Beobachtungszeitraum T — S10

Ermittlung der Spektralkreisfrequenzen $\omega_i$ der einzelnen Spektrallinien $\underline{A}_i$ des ideal rauschfreien Signals $x(t)$ — S20

Ermittlung der Koeffizienten der System-Matrix $\overline{\overline{S}}$ und des Vektors $\underline{b}$ der "rechten Gleichungsseite" des linearen Gleichungssystems — S30

Ermittlung des Betrags $|\underline{A}_i|$ und der Phase $\varphi_i$ der komplexen Spektrallinien $\underline{A}_i$ durch Lösen des linearen Gleichnungssystems — S40

ENDE

Fig. 1

START

Ermittlung/Schätzung der Trägerkreisfrequenz $\omega_T$ und der Modulationskreisfrequenz $\omega_{Mod}$ für das zu bildende AM-Signal ⟶ S110

Messen des AM-Signals über
den Beobachtungszeitraum T ⟶ S120

Ermitteln der Beträge $|\underline{A}_i|$ der Spektrallinien $\underline{A}_i$
des Signals x(t) bei der Trägerfrequenz $\omega_T$
und am oberen/unteren Seitenband $\omega_T \pm \omega_{Mod}$
aus dem linearen Gleichungssystem ⟶ S130

Berechnung des Modulationsgrades m aus den
Beträgen der 3 ermittelten Spektrallinien $\underline{A}_i$ ⟶ S140

ENDE

Fig. 2

Fig. 3

Fig. 5

Fig. 7

START

Einstellung der Trägerkreisfrequenz $\omega_T$ und der variierten Modulationskreisfrequenzen $\omega_{Modi}$ —S210

Messen des rauschbehafteten AM-Signals $m_{AM}(t)$ über den Beobachtungszeitraum T —S220

Ermitteln der Beträge $|\underline{A}_i|$ und Phasen $\varphi_i$ der Spektrallinien $\underline{A}_i$ des Signals $x(t)$ bei den Spektralkreisfrequenzen $\omega_T \pm \omega_{Modi}$ —S230

Berechnung der relativen Amplitudenverzerrungen $|\underline{A}_i| / |\underline{A}_T|$ und relativen Phasenverzerrungen $\Delta\varphi_i = \varphi_i - \varphi_T$ —S240

ENDE

Fig. 4

START

Einstellung der Trägerkreisfrequenz $\omega_T$ und der Modulationskreisfrequenz $\omega_{Mod}$ und Messen des rauschbehafteten Signals m(t) über den Beobachtungszeitraum T ⟋ S310

Ermitteln der komplexen Spektrallinien $\underline{A}_i$ des nichtlinear verzerrten Signals x(t) bei den Spektralkreisfrequenzen $\omega_i = n \cdot \omega_T \pm k \cdot \omega_{Mod}$ ⟋ S320

Optional: Kompensation der komplexen Spektrallinien $\underline{A}_i$ der Höherharmonischen und Intermodulationsprodukte durch entsprechende komplexe Spektrallinien $\underline{A}_{kli}$ eines Kompensationssignals ⟋ S330

ENDE

Fig. 6

Fig. 8

Fig. 9

START

insgesamt n diskrete Spektrallinien eines
N Ton-Signals auswählen — S610

alle Kreisfrequenzkombinationen der Intermodulationsprodukte der n Grundanteile im
interessierende Spektralfrequenzbereich berechnen — S620

mehrere Leistungspegel am Eingangssignal
(Grundanteile) einstellen und nicht-linear
verzerrtes Ausgangssignal messen — S630

für jedes nicht-linear verzerrtes Ausgangssignal
die Spektrallinien bei den berechneten Kreisfrequenzkombinationen mittels linearen
Gleichungssystem ermitteln — S640

die berechneten Leistungspegel der Spektrallinien
gleicher Ordnung für jeden Leistungspegel des
Eingangssignal addieren und ermittelte
Leistungsübertragung für jede Ordnung
der Spektrallinien darstellen — S650

ENDE

Fig. 10

START

Messen des gestörten rauschbehafteten
Signals m(t) über den Beobachtungszeitraum T — S410

Ermitteln der Spektralfrequenzen $\omega_i$
der harmonischen Störsignalanteile im
gestörten Nutzsignal $x_{Nutz}(t)$ — S420

Bestimmen des Betrags $|\underline{A}_i|$ und der Phase $\varphi_{Si}$
der harmonischen Störsignalanteile im gestörten
Nutzsignal $x_{Nutz}(t)$ zu den Spektralfrequenzen $\omega_{Si}$
aus dem linearen Gleichungssystem — S430

Ermitteln der Beträge $|\underline{A}_{k2i}|$ und der Phasen $\varphi_{k2i}$
der komplexen Spektrallinien $\underline{A}_{k2i}$ des Kompensationssignals $k_2(t)$ und Überlagerung des gestörten Nutzsignal $x_{Nutz}(t)$ mit dem ermittelten
Kompensationssignal $k_2(t)$ — S440

ENDE

Fig. 11

Spektrum

Störlinie

Nutzsignal-
Spektrum

ω

Fig. 12A

Phasenrauschen

Störlinie

Bereinigte Messkurve

ω

Fig. 12B

START

Ermitteln der Trägerkonfiguration für jedes verwendete OFDM-Signal $x_{OFDMi}$ — S510

Messen des aktuell empfangenen OFDM-Signals $x_{OFDM}(t)$ über den Beobachtungszeitraum T — S520

Ermitteln der Beträge $|\underline{A}_{Tij}|$ der komplexen Spektrallinien $\underline{A}_{Tij}$ für jede Spektralkreisfrequenz $\omega_{Tij}$ der Trägerkonfiguration jedes verwendeten OFDM-Signals aus dem linearen Gleichungssystems auf der Basis des aktuell gemessenen OFDM-Signals — S530

Bewerten der ermittelten Beträge $|\underline{A}_{Tij}|$ der komplexen Spektrallinien $\underline{A}_{Tij}$ für jedes verwendete OFDM-Signal mittels einer Metrik $L_i$ — S540

Bestimmung,welches OFDM-Signal aktuell gemessen wurde,anhand der Metrik $L_i$ mit der maximalen Bewertung — S550

ENDE

Fig. 13

Fig. 14A

Fig. 14B

$m \longrightarrow$

$$
\underbrace{\begin{pmatrix}
\int_0^T e^{j(\omega_1-\omega_1)t}\,dt & \int_0^T e^{j(\omega_2-\omega_1)t}\,dt & \cdots & \int_0^T e^{j(\omega_m-\omega_1)t}\,dt & \int_0^T e^{j(\omega_{N-1}-\omega_1)t}\,dt & \int_0^T e^{j(\omega_N-\omega_1)t}\,dt \\
\int_0^T e^{j(\omega_1-\omega_2)t}\,dt & \int_0^T e^{j(\omega_2-\omega_2)t}\,dt & \cdots & \cdots & \cdots & \int_0^T e^{j(\omega_N-\omega_2)t}\,dt \\
\cdots & \cdots & \cdots & \cdots & \cdots & \\
\int_0^T e^{j(\omega_1-\omega_n)t}\,dt & \cdots & \cdots & \cdots & \cdots & \cdots \\
\cdots & \cdots & \cdots & \cdots & \int_0^T e^{j(\omega_{N-1}-\omega_{N-1})t}\,dt & \int_0^T e^{j(\omega_N-\omega_{N-1})t}\,dt \\
\cdots & \cdots & \cdots & \cdots & \cdots & \int_0^T e^{j(\omega_N-\omega_N)t}\,dt
\end{pmatrix}}_{\overline{S}}
\cdot
\underbrace{\begin{pmatrix} A_1 \\ A_2 \\ \cdots \\ A_{N-1} \\ A_N \end{pmatrix}}_{\underline{A}}
=
\underbrace{\begin{pmatrix}
\int_0^T m(t)e^{-j\omega_1 t}\,dt \\
\int_0^T m(t)e^{-j\omega_2 t}\,dt \\
\cdots \\
\cdots \\
\int_0^T m(t)e^{-j\omega_{N-1} t}\,dt \\
\int_0^T m(t)e^{-j\omega_N t}\,dt
\end{pmatrix}}_{\underline{b}}
$$

$n \downarrow \qquad\qquad m \downarrow$

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10105258 A1
- US 2003014203 A1